(19) Europäisches Patentamt / European Patent Office / Office européen des brevets

(11) **EP 2 518 770 B1**

(12) **FASCICULE DE BREVET EUROPEEN**

(45) Date de publication et mention
de la délivrance du brevet:
**09.12.2015   Bulletin 2015/50**

(51) Int Cl.:
*H04N 5/225* *(2006.01)*     *H01L 27/146* *(2006.01)*
*H04N 5/232* *(2006.01)*

(21) Numéro de dépôt: **12165737.3**

(22) Date de dépôt: **26.04.2012**

(54) **Dispositif imageur destiné à evaluer des distances d'éléments dans une image**

Abbildungsvorrichtung  zum Bestimmen des Abstands von Objekten in einem Bild

Imaging device for measuring distances of elements in an image

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **28.04.2011   FR 1153643**

(43) Date de publication de la demande:
**31.10.2012   Bulletin 2012/44**

(73) Titulaire: **Commissariat à l'Énergie Atomique
et aux Énergies Alternatives
75015 Paris (FR)**

(72) Inventeur: **Gidon, Pierre
38130 ECHIROLLES (FR)**

(74) Mandataire: **Ilgart, Jean-Christophe et al
BREVALEX
95, rue d'Amsterdam
75378 Paris Cedex 8 (FR)**

(56) Documents cités:
**EP-A2- 0 833 502          EP-A2- 2 299 491
US-A- 5 592 223          US-A1- 2007 014 019
US-A1- 2009 261 439**

## Description

## DOMAINE TECHNIQUE

L'invention concerne le domaine de la capture d'images à partir desquelles il est possible de déterminer les distances entre des objets ou éléments observés et l'emplacement de la prise de vue des images. Dans de telles images, appelées cartes de profondeur (« depth map » en anglais), la luminosité et/ou la couleur représentées sont par exemple fonction de cette distance. L'invention concerne notamment un dispositif imageur réalisant une telle capture d'images, appelé aussi caméra Z.

## ÉTAT DE LA TECHNIQUE ANTÉRIEURE

Dans le domaine de la capture de cartes de profondeur, les dispositifs imageurs sont dits actifs ou passifs selon qu'ils font appel ou non à une source de lumière supplémentaire par rapport à la lumière incidente reçue par le dispositif et provenant de la scène.

Le document EP 2 299 491 décrit un dispositif imageur apte à capturer une image en trois dimensions.

Dans le cas des dispositifs imageurs passifs, la carte de profondeur est en général extraite et construite à partir d'images acquises avec des circuits intégrés imageurs classiques, c'est-à-dire des circuits intégrés imageurs aptes à réaliser une capture d'images standards. Les cartes de profondeurs sont obtenues en réalisant des calculs complexes à partir de plusieurs images capturées successivement ou prises côte-à-côte.

Un dispositif imageur passif est par exemple utilisé dans les systèmes autofocus des appareils photo de type réflexe. Ce genre de dispositif imageur est complexe et intègre un nombre important de photodétecteurs ainsi qu'un système optique en chaque point de mesure. Les systèmes les plus performants détectent jusqu'à un millier de points de mesure dont ils déterminent les valeurs de dé-focalisation de l'optique. A partir de ces informations, il est possible de déterminer la distance d'un objet, mais pas d'obtenir une carte de profondeur.

Une camera dite « Plenoptic » peut aussi être utilisée pour obtenir une carte de profondeur. Là aussi, la structure de cette caméra est complexe et très consommatrice de pixels.

## EXPOSÉ DE L'INVENTION

Un but de la présente invention est de proposer un nouveau dispositif imageur qui soit apte à réaliser une capture de carte de profondeur, c'est-à-dire apte à délivrer des informations permettant de déterminer aisément une distance entre un ou plusieurs éléments de la scène capturée et le dispositif imageur, ne nécessitant pas de source de lumière additionnelle ni de système optique particulier, et qui ne nécessite pas, à résolution équivalente, un nombre important de pixels par rapport à un dispositif imageur classique.

Pour cela, la présente invention propose un dispositif imageur comme décrit dans la revendication 1 et comportant au moins :

- un circuit intégré imageur comprenant une matrice de pixels destinés à recevoir des rayons lumineux issus d'une scène,
- plusieurs premiers, deuxièmes et troisièmes moyens de focalisation disposés les uns à côté des autres sur la matrice de pixels, entre la matrice de pixels et une face d'entrée des rayons lumineux dans le dispositif imageur, tels que chacun desdits moyens de focalisation soit disposé en regard d'un groupe d'au moins quatre desdits pixels associés au dit moyen de focalisation et formant une matrice $2 \times 2$, et soit apte à réaliser une focalisation d'une partie des rayons lumineux vers ledit groupe de pixels associés, les focalisations réalisées par les premiers, deuxièmes et troisièmes moyens de focalisation étant différentes les unes par rapport aux autres,
- des quatrièmes moyens aptes à laisser passer, vis-à-vis de chaque groupe de pixels, les rayons lumineux orientés vers ledit groupe de pixels et traversant le moyen de focalisation associé au dit groupe de pixels, et aptes à bloquer les rayons lumineux orientés vers ledit groupe de pixels et traversant les autres moyens de focalisation.

Les focalisations réalisées par les premiers, deuxièmes et troisièmes moyens de focalisation sont différentes les unes par rapport aux autres et équivalentes à une disposition des groupes de pixels associés à trois distances différentes vis-à-vis de la face d'entrée des rayons lumineux dans le dispositif imageur.

Le dispositif selon l'invention est passif au sens où il ne nécessite pas de source de lumière supplémentaire autre que la lumière incidente pour obtenir l'information relative à la distance à calculer.

Le dispositif imageur selon l'invention n'intervient pas activement sur le système optique, comme le font par exemple les systèmes à essais successifs d'une recherche du meilleur contraste entre plusieurs images par variation de la position de focalisation d'une optique. Le dispositif imageur selon l'invention permet de réaliser une capture d'image instantanée à partir de laquelle on peut obtenir directement, à partir des signaux électriques délivrés par les pixels, une information de profondeur relative aux éléments présents sur l'image.

Le dispositif imageur selon l'invention fait appel à une matrice de pixels classique et peut donc être réalisé à partir d'un circuit intégré imageur traditionnel. Dans le dispositif imageur selon l'invention, on ajoute sur le circuit intégré imageur des moyens de focalisation modifiant l'information capturée par les pixels de manière à ce que les signaux délivrés par les pixels puissent être utilisés pour extraire d'autres informations que l'habituelle intensité lumineuse en chaque point de l'image capturée. Les trois différentes focalisations réalisées par les premiers, deuxièmes et troisièmes moyens de focalisation peuvent notamment être équivalentes à trois différentes mises au point vis-à-vis des groupes de pixels associés, c'est-à-dire un effet équivalent à une disposition des groupes de pixels à trois distances différentes vis-à-vis de la face d'entrée des rayons lumineux dans le dispositif imageur (cette distance « simulée » est la même pour les au moins 4 pixels faisant partie d'un même groupe de pixels). En particulier, il est possible de déterminer facilement la position et l'orientation des contours des éléments dans l'image capturée, ce qui permet de déterminer ensuite des distances de ces contours dans une large gamme de valeurs. Cette gamme peut être dépendante de la focale d'un système optique utilisé dans le dispositif imageur pour faire converger les rayons lumineux issus de la scène vers la matrice de pixels. Ce dispositif imageur a donc un angle de champ et une profondeur de champ permettant de réaliser une détermination des coordonnés X, Y et Z des éléments de la scène qui est capturée.

Enfin, aucun mouvement du dispositif imageur ni aucune source de lumière supplémentaire ne sont nécessaires à l'invention.

Il est également proposé un dispositif imageur comportant au moins :

- un circuit intégré imageur comprenant une matrice de pixels destinés à recevoir des rayons lumineux issus d'une scène,
- plusieurs premières, deuxièmes et troisièmes portions d'au moins un matériau optiquement transparent, respectivement d'épaisseurs $e_1$, $e_2$ et $e_3$ non nulles et telles que $e_1 > e_2 > e_3$, disposées les unes à côté des autres entre la matrice de pixels et une face d'entrée des rayons lumineux dans le dispositif imageur, telles que chacune desdites portions de matériau optiquement transparent recouvre au moins en partie un groupe d'au moins quatre desdits pixels associés à ladite portion de matériau optiquement transparent et formant une matrice $2 \times 2$,
- des moyens aptes à laisser passer, vis-à-vis de chacun desdits groupes de pixels, les rayons lumineux orientés vers ledit groupe de pixels et traversant la portion de matériau optiquement transparent recouvrant ledit groupe de pixels, et aptes à bloquer les rayons lumineux orientés vers ledit groupe de pixels et traversant les autres portions de matériau optiquement transparent,

l'indice de réfraction du matériau optiquement transparent étant différent de l'indice de réfraction d'au moins un matériau et/ou un gaz présent entre la face d'entrée des rayons lumineux et lesdits moyens.

Chacun des premiers, deuxièmes et troisièmes moyens de focalisation peut comporter respectivement une première, une deuxième et une troisième portion d'au moins un matériau optiquement transparent d'épaisseurs $e_1$, $e_2$ et $e_3$ non nulles et telles que $e_1 > e_2 > e_3$, et dans lequel l'indice de réfraction du matériau optiquement transparent est différent de l'indice de réfraction d'au moins un matériau et/ou un gaz présent entre la face d'entrée des rayons lumineux et les moyens de focalisation.

Dans ce cas, pour chacune des portions de matériau optiquement transparent, au moins deux des portions de matériau optiquement transparent adjacentes peuvent comporter des épaisseurs différentes de celle de ladite portion de matériau optiquement transparent.

Il est également possible que pour chacune des portions de matériau optiquement transparent, toutes les portions de matériau optiquement transparent adjacentes puissent comporter des épaisseurs différentes de celle de ladite portion de matériau optiquement transparent.

Les quatrièmes moyens peuvent comporter au moins une couche opaque recouvrant les portions de matériau optiquement transparent et qui peut être traversée par une pluralité d'ouvertures formant chacune, vis-à-vis de chacun desdits groupes de pixels, un diaphragme.

Chaque ouverture peut comporter, dans un plan parallèle à la face d'entrée des rayons lumineux dans le dispositif imageur, une section sensiblement circulaire, et/ou le centre de chaque ouverture peut être espacée du centre d'une ouverture voisine d'une distance supérieure à environ deux fois une dimension (par exemple la dimension d'un côté ou un diamètre) d'un pixel, et/ou chaque ouverture peut présenter des dimensions inférieures à celles d'un desdits groupes de quatre pixels (dimension d'un côté ou un diamètre dudit groupe de quatre pixels), et/ou chaque ouverture peut être sensiblement centrée en regard d'une limite entre deux pixels adjacents.

Le dispositif imageur peut comporter en outre un système optique apte guider les rayons lumineux issus de la scène vers la matrice de pixels. Un tel système optique peut correspondre à une optique, plus ou moins complexe, par exemple une simple lentille, permettant de faire converger les rayons lumineux capturés par le dispositif imageur vers les moyens de focalisation disposés sur la matrice de pixels. La convergence réalisée par le système optique peut déterminer la gamme de profondeur capturée, cette gamme de profondeur pouvant être ajustée en ajustant la convergence réalisée par le système optique lorsque le centre optique vu par le dispositif imageur est fixe.

Chaque ouverture peut être centrée par rapport à une droite passant par le centre optique du système optique et le centre du groupe de pixels dont l'ouverture forme un diaphragme.

Dans une autre variante, les quatrièmes moyens peuvent comporter une première matrice de filtres colorés disposés entre la matrice de pixels et les portions de matériau optiquement transparent, et une seconde matrice de filtres colorés recouvrant les portions de matériau optiquement transparent, chaque filtre de la première matrice recouvrant un desdits groupes de pixels et chaque filtre de la seconde matrice recouvrant une desdites portions de matériau optiquement transparent, les spectres d'absorption lumineuse de deux filtres colorés sensiblement superposés de la première et de la seconde matrice étant sensiblement similaires.

La première et/ou la seconde matrice de filtres colorés peut comporter des premiers, deuxièmes, troisièmes et quatrièmes filtres colorés comprenant des spectres d'absorption lumineuse différents.

Au moins une partie des portions de matériau optiquement transparent peuvent comporter une surface d'entrée des rayons lumineux formant un dioptre en creux ou en bosse. On peut ainsi réaliser des lentilles dont leurs contours sont suffisamment différents de la courbure de l'onde incidente pour empêcher l'annulation de la réfraction, une telle annulation se produisant lorsque les rayons lumineux arrivent perpendiculairement à leur surface d'entrée.

Chacun des premiers, deuxièmes et troisièmes moyens de focalisation peut comporter respectivement une première, une deuxième et une troisième lentille, ou micro-lentille, de convergences différentes.

Dans ce cas, les quatrièmes moyens peuvent comporter des portions de matériau opaque disposées entre les lentilles.

Le dispositif imageur peut comporter en outre au moins une couche de matériau optiquement transparent disposée entre la matrice de pixels et les lentilles.

Les premières ou les deuxièmes ou les troisièmes lentilles peuvent correspondre à des portions de sphères dont les centres correspondent sensiblement aux centres des groupes de pixels associés auxdites lentilles.

Les quatrièmes moyens peuvent comporter une matrice de filtres optiques disposés entre la matrice de pixels et les lentilles, chaque filtre optique de la matrice recouvrant un desdits groupes de pixels, les spectres d'absorption lumineuse de deux filtres optiques adjacents étant différents.

Les quatrièmes moyens peuvent comporter :

- des premiers filtres optiques dont les spectres d'absorption lumineuse coupent les longueurs d'ondes dans le domaine visible et laissent passer au moins une partie des longueurs d'ondes du domaine infrarouge et/ou ultraviolet, chaque premier filtre optique étant disposé entre une lentille et le groupe de pixels associés à ladite lentille,
- des deuxièmes filtres optiques dont les spectres d'absorption lumineuse laissent passer une partie des longueurs d'ondes du domaine visible et coupent les longueurs d'ondes du domaine infrarouge et ultraviolet,

les premiers et deuxièmes filtres optiques étant disposés de manière alternés au sein d'une même matrice de filtres optiques disposée entre la matrice de pixels et les lentilles.

Les premiers filtres optiques peuvent être disposés tels qu'ils forment une matrice de Bayer.

Le dispositif imageur peut comporter en outre un système optique apte guider les rayons lumineux issus de la scène vers la matrice de pixels.

Chaque lentille peut être centrée par rapport à une droite passant par le centre optique du système optique et le centre du groupe de pixels associés à ladite lentille.

Le système optique peut être couplé à au moins un miroir comprenant au moins un trou tel qu'une première partie des rayons lumineux soient reflétés vers ledit circuit intégré imageur par les parties du miroir périphériques au trou et qu'une seconde partie des rayons lumineux soient guidés vers un autre circuit intégré imageur à travers le trou.

Les moyens de focalisation peuvent être disposés en quinconce les uns par rapport aux autres.

Dans une variante, les moyens de focalisation peuvent être disposés sous la forme d'une matrice telle que chaque groupe de cinq moyens de focalisation alignés comporte au moins un de chacun des premiers, deuxièmes et troisièmes moyens de focalisation.

Ainsi, une telle répartition peut former un pavage pseudo aléatoire permettant d'avoir une répartition sensiblement uniforme des différentes convergences réalisées par les différents moyens de focalisation sur l'ensemble de la matrice de pixels.

Des lignes d'interconnexions électriques reliées électriquement à des photodétecteurs des pixels peuvent être disposées en périphérie desdits groupes de pixels.

Le dispositif imageur peut comporter en outre des moyens de calcul aptes à calculer, à partir de signaux électriques délivrés par les pixels, une distance entre le dispositif imageur et au moins un élément de la scène.

Il est également proposé un procédé de réalisation d'un dispositif imageur comportant au moins les étapes de :

- réalisation d'un circuit intégré imageur comprenant une matrice de pixels destinés à recevoir des rayons lumineux issus d'une scène,
- réalisation de plusieurs premiers, deuxièmes et troisièmes moyens de focalisation disposés les uns à côté des autres sur la matrice de pixels, entre la matrice de pixels et une face d'entrée des rayons lumineux dans le dispositif imageur, tels que chacun desdits moyens de focalisation soit disposé en regard d'un groupe d'au moins quatre desdits pixels associés au dit moyen de focalisation et formant une matrice 2×2, et soit apte à réaliser une focalisation d'une partie des rayons lumineux vers ledit groupe de pixels associés, les focalisations réalisées par les premiers, deuxièmes et troisièmes moyens de focalisation étant différentes les unes par rapport aux autres,

- réalisation de quatrièmes moyens aptes à laisser passer, vis-à-vis de chaque groupe de pixels, les rayons lumineux orientés vers ledit groupe de pixels et traversant le moyen de focalisation associé au dit groupe de pixels, et aptes à bloquer les rayons lumineux orientés vers ledit groupe de pixels et traversant les autres moyens de focalisation.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- les figures 1 et 2 représentent un dispositif imageur, objet de la présente invention, selon un premier mode de réalisation,
- la figure 3 représente la réfraction et la focalisation se produisant dans un dispositif imageur, objet de la présente invention, selon le premier mode de réalisation,
- la figure 4 représente un groupe de quatre pixels d'un dispositif imageur objet de la présente invention,
- les figures 5 et 6 représentent des exemples de répartition des moyens de focalisation dans un dispositif imageur, objet de la présente invention,
- la figure 7 représente un dispositif imageur, objet de la présente invention, selon un second mode de réalisation,
- la figure 8 représente un exemple d'une matrice de filtres colorés du dispositif imageur, objet de la présente invention, selon le second mode de réalisation,
- la figure 9 représente une variante de réalisation des portions de matériau optiquement transparent d'un dispositif imageur, objet de la présente invention,
- la figure 10 représente un dispositif imageur, objet de la présente invention, selon un troisième mode de réalisation,
- les figures 11 et 12 représentent un dispositif imageur, objet de la présente invention, selon un quatrième mode de réalisation,
- les figures 13 et 14 représentent un dispositif imageur, objet de la présente invention, respectivement selon un cinquième et un sixième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

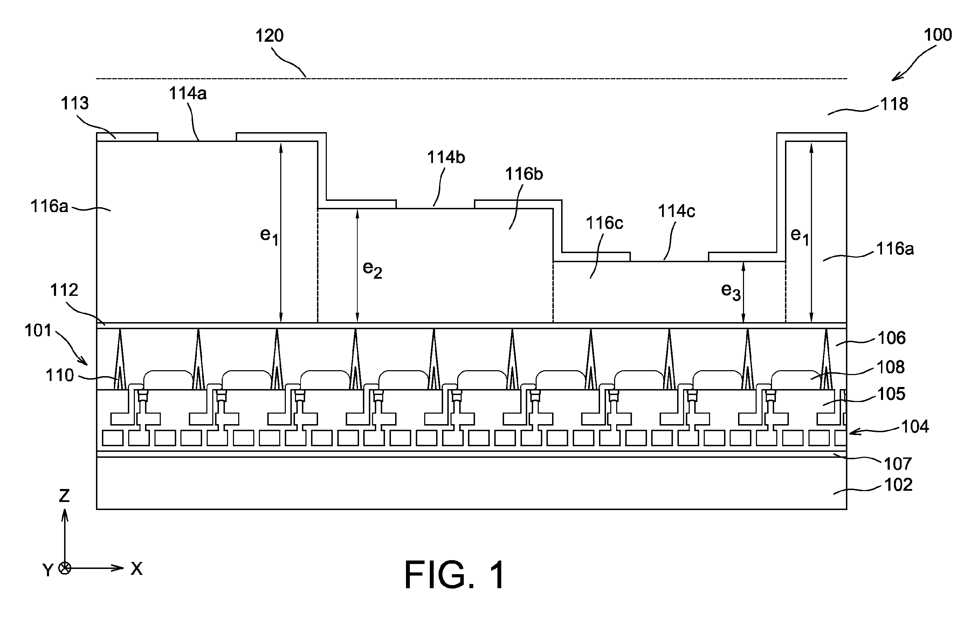

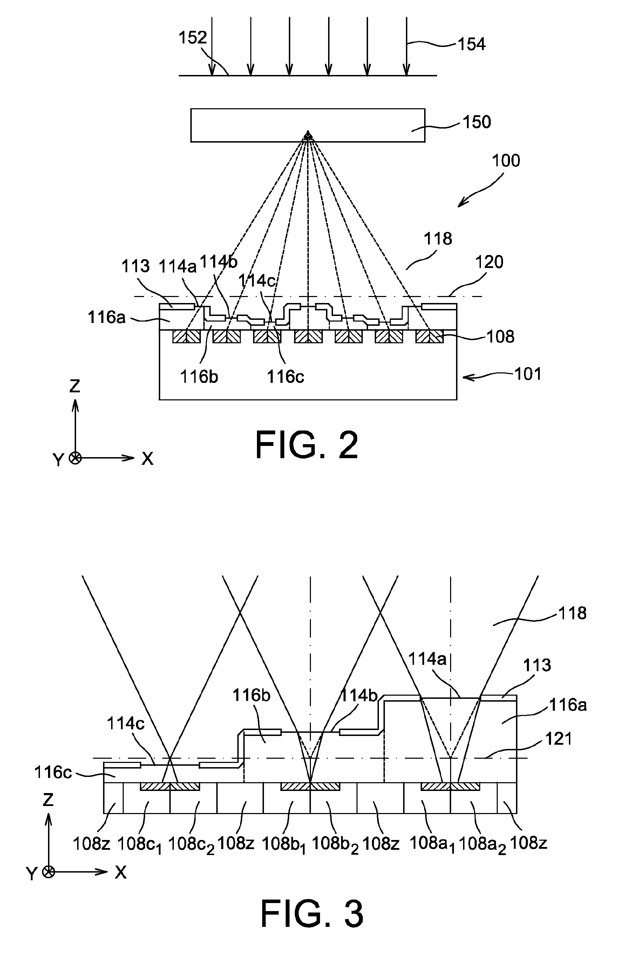

On se réfère tout d'abord aux figures 1 et 2 qui représentent schématiquement un dispositif imageur 100 selon un premier mode de réalisation.

Le dispositif imageur 100 comporte un circuit intégré imageur 101 comprenant un support 102 sur lequel sont disposés plusieurs niveaux de lignes d'interconnexions électriques 104, par exemple à base de métal. Les lignes d'interconnexions électriques 104 sont disposées dans une couche diélectrique 105 recouvrant le support 102 et solidarisée au support 102 par l'intermédiaire d'une couche de collage 107. Une couche de semi-conducteur 106 recouvre la couche diélectrique 105. Le circuit intégré imageur 101 comporte une pluralité de photodétecteurs, ici des photodiodes comportant des zones dopées de semi-conducteur couplées à des transistors MOS, et disposés sous la forme d'une matrice carrée, chacun des photodétecteurs formant un pixel 108 du dispositif imageur 100. Les photodétecteurs forment une matrice de pixels 108. Le circuit intégré imageur comporte également des portions de matériau 110 formant des séparations entre les pixels 108, au sein de la couche de semi-conducteur 106, composées par exemple de $SiO_2$ et éventuellement de silicium polycristallin. Enfin, la couche de semi-conducteur 106 est recouverte par une couche de passivation 112.

Le circuit intégré imageur 101 est ici de type backside, les rayons lumineux entrant dans le circuit intégré imageur 101 du côté de sa face arrière, c'est-à-dire du côté opposé à celui où se trouvent les lignes d'interconnexions électriques 104. Le circuit intégré imageur 101 pourrait avoir une structure différente de celle représentée sur la figure 1, et pourrait notamment être de type « front-side », les rayons lumineux étant dans ce cas destinés à entrer dans le dispositif imageur du côté de sa face avant. De manière générale, le dispositif imageur 100 peut comporter n'importe quel type de circuit intégré imageur comprenant une matrice de pixels.

Le dispositif imageur 100 comporte également, au-dessus du circuit intégré imageur 101, un masque comprenant une couche opaque 113, c'est-à-dire une couche formée d'un matériau apte à bloquer des rayons lumineux incidents, par exemple une couche métallique comprenant de l'aluminium, dans laquelle sont formées de multiples ouvertures 114 disposées à différentes distances des photodétecteurs des pixels 108. Le masque forme donc une structure comportant des ouvertures 114 disposées sur différents niveaux, ou à différentes hauteurs vis-à-vis de la matrice de pixels 108. Cette disposition en différents niveaux est obtenue grâce à des portions de matériau optiquement transparent 116 d'épaisseurs différentes disposées entre le circuit intégré imageur 101 et la couche opaque 113. Le dispositif imageur 100 comporte plusieurs premières portions 116a de matériau optiquement transparent d'épaisseur $e_1$, plusieurs deuxièmes portions 116b de matériau optiquement transparent d'épaisseur $e_2$ et plusieurs troisièmes portions 116c de matériau optiquement transparent d'épaisseur $e_3$, avec $e_1 > e_2 > e_3$. Chacune des portions 116a, 116b, 116c est recouverte d'une partie de la couche opaque 113 comportant respectivement une ouverture 114a, 114b et 114c. Les épaisseurs $e_1$, $e_2$ et $e_3$ sont par exemple comprises entre environ 1 $\mu$m et 100 $\mu$m. Il est par exemple possible d'avoir dans une première configuration : $e_1 = 1$ $\mu$m ; $e_2 = 2$ $\mu$m et $e_3 = 3$ $\mu$m. Dans une seconde configuration, on peut avoir $e_1 = 3$ $\mu$m ; $e_2 = 15$ $\mu$m et $e_3 = 80$ $\mu$m.

Ces portions 116 sont réalisées, par exemple, à partir d'une couche (ou de plusieurs couches déposées successivement les unes contre les autres) de matériau optiquement transparent formée sur la couche de passivation 112 et structurée telle qu'elle forme ces différentes portions d'épaisseurs différentes. Le matériau optiquement transparent de ces portions 116a, 116b et 116c a un indice de réfraction, ou indice optique, différent de celui d'un matériau et/ou un gaz 118 (ou plus généralement un fluide), se trouvant au-dessus de la couche opaque 113 (de l'air dans l'exemple de la figure 1). Le matériau optiquement transparent pourra être choisi tel qu'il présente un indice optique le plus différent possible du matériau et/ou du gaz 118. Le matériau ou gaz 118 peut également être du vide ou un matériau dont l'indice optique est très proche de 1, par exemple du $MgF_2$ ou du $SiO_2$ poreux. Lorsque l'on dispose un matériau 118 au-dessus des portions 116 de matériau optiquement transparent, le dispositif 100 peut comporter dans ce cas une face supérieure plane.

Compte tenu de cette différence entre l'indice de réfraction du matériau des portions 116 et l'indice de réfraction de l'air 118, et du fait que les portions 116 ont des épaisseurs différentes, ces portions 116 de matériau optiquement transparent forment des moyens de focalisation des rayons lumineux vers la matrice de pixels. L'emplacement des points de focalisation des portions 116 et la distance entre ces points de focalisation et les pixels 108 varient en fonction de l'épaisseur du matériau optiquement transparent.

Le dispositif imageur 100 comporte également un système optique 150, représenté sur la figure 2, guidant des rayons lumineux 154 issus d'une scène vers la matrice de pixels 108, les rayons lumineux 154 entrant dans le dispositif imageur 100 par une face d'entrée 152 du dispositif imageur 100. Le système optique 150 correspond par exemple à un objectif comprenant une ou plusieurs lentilles. Le plan focal 120 du système optique 150 se situe devant le circuit intégré imageur 101, c'est-à-dire entre le système optique 150 et la matrice de pixels 108. Le système optique 150 forme une image standard, avec des zones nettes et des zones floues, sur le dispositif imageur 100.

Chaque portion de matériau optiquement transparent 116 recouvre au moins en partie un groupe d'au moins quatre pixels 108 du circuit intégré imageur 101, et est par exemple centrée par rapport au centre de la matrice 2×2 formée par ces quatre pixels 108.

Chaque ouverture 114 se trouve également en regard du groupe de pixels 108 recouverts par chacune des portions de matériau optiquement transparent 116. Les ouvertures 114 présentent par exemple chacune une section, dans un plan parallèle à la face d'entrée 152 du dispositif imageur 100 (parallèle au plan (X,Y) représenté sur les figures 1 et 2), de forme circulaire ou sensiblement circulaire. Les ouvertures 114 sont espacées les unes des autres telles que chacune d'elles soit disposée, selon les axes X et Y, par exemple tous les 3 pixels comme sur la figure 1 (les centres de deux ouvertures 114 adjacentes sont séparés d'une distance selon l'axe X égale ou sensiblement égale à la dimension de plusieurs pixels selon cet axe X (3 pixels dans l'exemple de la figure 1), et sont séparés d'une distance selon l'axe Y égale ou sensiblement égale à la dimension par exemple de trois pixels selon cet axe Y), chaque ouverture 114 formant un diaphragme vis-à-vis de chacun desdits groupes de quatre pixels 108. Le nombre d'ouvertures 114, et donc également le nombre de portions de matériau optiquement transparent 116, peut être égal à environ N/9 et au plus égal à N/4, avec N correspondant au nombre total de pixels 108 du circuit intégré imageur 101. Les ouvertures 114 ont ici chacune une taille (diamètre ou dimension d'un côté, selon la forme de l'ouverture) égale ou voisine de la dimension d'un côté d'un pixel. Plus généralement, les ouvertures 114 ont chacune une taille inférieure à deux fois la taille d'un pixel.

La position et le diamètre des ouvertures 114 au-dessus de chaque groupe de quatre pixels 108, ainsi que les dimensions des espaces entre ces groupes de pixels 108 dépendent de la focale du système optique 150. Sur l'exemple précédemment décrit en liaison avec la figure 2, les ouvertures 114 disposées au-dessus des pixels 108 sont légèrement décalées vis-à-vis des centres des groupes de quatre pixels 108 telles que chaque ouverture 114 soit centrée par rapport à une droite passant par le centre optique du système optique 150 et le centre du groupe de pixels 108 dont l'ouverture forme un diaphragme.

La figure 3 représente la réfraction se produisant dans trois portions de matériau optiquement transparent 116a, 116b, 116c d'épaisseurs différentes et disposées les unes à côté des autres, et donc la focalisation des rayons lumineux réalisée par ces portions de matériau optiquement transparent 116a, 116b, 116c. La figure 3 montre que la lumière provenant de trois points côte à côte, provenant d'une grande distance, loin devant le système optique 150, convergerait et se focaliserait sur un même plan 121 devant les pixels 108 s'il n'y avait pas les portions de matériau optiquement transparent 116 qui, par réfraction, déplacent les points de focalisation à des niveaux différents, ou hauteurs différentes, c'est-à-dire à des distances différentes des pixels 108. Ce déplacement des points de focalisation varie selon l'épaisseur des portions 116 et selon la valeur de l'indice de réfraction du matériau optiquement transparent de ces portions 116.

Seule une partie des rayons lumineux traversant les portions 116 sont représentés sur la figure 3. Or, l'angle de réfraction n'est pas une constante pour tous les rayons car ils ont des inclinaisons différentes. Le franchissement d'un dioptre plan, correspondant à une portion 116, permet de créer une aberration de sphéricité sur une onde sphérique incidente. Les rayons les plus proches de la normale au dioptre se focalisent à une distance différente de ceux plus éloignés de la normale. Cette aberration est d'autant plus grande que le champ angulaire ou bien l'ouverture du système optique est grand. L'aberration peut être minimisée ici, par exemple, en masquant le centre du système optique. Les rayons du centre, en général moins réfractés que ceux du bord ne contribuant plus, l'aberration est moindre. De plus, les rayons du centre de l'optique que l'on élimine ainsi sont connus pour agir sur les basses fréquences spatiales de l'image (variations à longue distance de l'intensité), mais pas sur les hautes fréquences spatiales (netteté de bords). En d'autres termes, le contraste global de l'image est modifié, mais le contraste local ne l'est pas, ce qui est plutôt favorable à la mesure de distance par contraste, notamment lorsque l'on réalise un masquage dit apodisant, c'est-à-dire introduisant une diffraction due au bord de masque sans rebonds ou anneaux.

Les ouvertures 114a, 114b, 114c forment des moyens aptes à laisser passer, vis-à-vis de chacun des groupes de pixels (quatre pixels dans l'exemple décrit ici) disposés en regard des ouvertures 114a, 114b, 114c, les rayons lumineux orientés vers ledit groupe de pixels et traversant la portion de matériau optiquement transparent 116a, 116b, 116c recouvrant ledit groupe de pixels. Les portions de la couche opaque 113 se trouvant entre les ouvertures 114a, 114b, 114c permettent par contre de bloquer les rayons lumineux orientés vers ledit groupe de pixels et traversant les autres portions de matériau optiquement transparent ne recouvrant pas ledit groupe de pixels. Sur l'exemple de la figure 3, l'ouverture 114b laisse donc passer des rayons qui traversent la portion de matériau transparent 116b et qui atteignent le groupe de quatre pixels dont font partie les deux pixels $108b_1$, $108b_2$. Les autres rayons orientés vers le groupe de quatre pixels dont font partie les deux pixels $108b_1$, $108b_2$ mais qui devraient traverser des portions de matériau transparent autres que la portion 116b sont bloqués par la couche opaque 113. Cela évite d'avoir des interférences entre les rayons lumineux reçus par chaque groupe de pixels. Il en est de même des ouvertures 114c et 114a qui laissent passer des rayons qui traversent respectivement les portions de matériau transparent 116c et 116a, et qui atteignent les groupes de quatre pixels dont font partie respectivement les pixels $108c_1$, $108c_2$ et $108a_1$, $108a_2$.

On voit sur l'exemple de la figure 3 que les groupes de quatre pixels destinés à recevoir les rayons lumineux à travers les ouvertures 114 sont par exemple espacés les uns des autres d'une distance équivalente à un pixel. Les pixels référencés 108z sur la figure 3 ne sont donc pas destinés à délivrer des signaux utilisés directement pour déterminer une carte de profondeurs.

Ces pixels 108z forment, autour de chaque groupe de pixels destinés à capturer des rayons lumineux, un intervalle permettant d'éviter les interférences avec les rayons lumineux qui ne sont pas destinés à être capturés par le groupe de pixels. La largeur de cet intervalle (égale à un pixel sur l'exemple de la figure 3) est liée aux dimensions de l'ouverture optique du système optique : plus les dimensions de cette ouverture optique sont grandes, plus les intervalles séparant les groupes de pixels sont larges, et inversement (plus les dimensions de l'ouverture optique sont petites, plus les intervalles séparant les groupes de pixels sont étroits).

Les trois différentes distances entre les ouvertures 114a, 114b, 114c et les pixels 108, réalisant des focalisations différentes des rayons lumineux sur les pixels, ont donc un effet équivalent à une disposition des groupes de pixels 108 à trois distances différentes vis-à-vis du système optique 150 et vis-à-vis de la face d'entrée 152. Sur l'exemple de la figure 3, l'interface d'entrée des rayons lumineux dans les portions 116a, 116b, 116c, au niveau des ouvertures 114a, 114b, 114c, est plane et le matériau optiquement transparent des portions 116a, 116b, 116c a un indice de réfraction plus élevé que celui du matériau ou gaz 118 se trouvant au-dessus de la couche opaque 113. Dans ce cas, plus l'épaisseur de la portion de matériau optiquement transparent 116 est grande, plus le pixel 108 est optiquement approché du système optique convergent 150. Du fait que les portions de matériau optiquement transparent 116 permettent de réaliser un rapprochement ou un éloignement différent selon les pixels, il est donc possible de déterminer, à partir des signaux électriques délivrés par les pixels 108 du dispositif imageur 100, la distance des objets dont les rayons lumineux sont capturés par le dispositif imageur 100, par rapport au dispositif imageur 100 (et notamment par rapport au système optique 150).

Il existe un pas, ou distance, sensiblement constant (le pas varie légèrement avec le champ optique du fait de la réfraction) entre les ouvertures 114 d'un même niveau, c'est-à-dire entre les ouvertures disposées sur des portions de matériau optiquement transparent 116 de même épaisseur, ce pas étant différent pour chaque niveau, et également différent du pas entre les groupes de pixels 108.

L'espacement entre les groupes de pixels (groupe de quatre pixels dans les exemples précédemment décrits) est choisi tel que la lumière provenant de tout le système optique 150 et passant par l'une des ouvertures 114 ne peut pas atteindre un groupe de pixel autre que celui se trouvant en regard de cette ouverture 114.

Lorsque les portions de la couche opaque 113 masquent, entre chaque groupe de pixels 108, un ou plusieurs autres pixels (référencés 108z sur l'exemple de la figure 3) autour dudit groupe de pixels, les signaux fournis par ces pixels masqués, qui peuvent recevoir des rayons initialement destinés à des groupes de pixels adjacents, peuvent toutefois être utilisés pour affiner la mesure réalisée.

Les calculs réalisés à partir des signaux délivrés par les pixels 108 et permettant de déterminer la distance des objets sont réalisés en faisant les hypothèses suivantes :

- Les images des objets sont à des positions de hauteurs différentes vis-à-vis du dispositif imageur 100 dépendant de l'éloignement des objets.
- Les objets à l'infini ont une image nette sur le plan passant par la focale du système optique 150 (plan 120) et une image de plus en plus floue en s'éloignant de ce plan 120. Par contre les objets plus proches du système optique 150 forment une image nette plus loin, en direction des pixels 108, que le plan focal 120 du système optique 150.

- La netteté dans une image est déterminée à partir des limites, ou contours, entre les différents éléments de l'image. Les plages uniformes n'ont pas de notion de netteté. La netteté est déterminée à partir du contraste de la limite elle-même, mais aussi à partir du contraste au voisinage de la limite.
- La variation de contraste passe par un extrémum (cas où le point de focalisation se situe au niveau des pixels) et c'est la position de cet extrémum qui permet notamment de déterminer la distance.

Il y a donc trois cas possibles pour l'image capturé par le dispositif imageur 100 :

- Si l'image d'une limite passe par une des ouvertures 114 de la couche opaque 113, au moins un des pixels 108 capturant cette image délivre un signal d'intensité différente des signaux délivrés par les autres pixels du groupe. Dans ce cas, plus les pixels 108 seront proches du plan de netteté de l'image, plus cette différence d'intensité sera grande (équivalent à un fort contraste).
- Si l'image d'une limite passe à coté d'une des ouvertures 114 de la couche opaque 113 tout en étant proche de cette ouverture, les pixels 108 du groupe se trouvant sous cette ouverture vont délivrés des signaux d'intensités graduellement différents (équivalent à une zone floue). Dans ce cas, plus les pixels seront proches du plan de netteté de l'image, plus la différence entre les signaux délivrés par les pixels du groupe sera faible (équivalente à un faible contraste).
- Dans le cas d'ouvertures 114 éloignées de toutes limites, aucune variation de contraste n'est obtenue dans les signaux délivrés par les pixels 108 se trouvant en regard de ces ouvertures 114, les signaux délivrés par les différents blocs de quatre pixels 108 étant quasi-identiques.

L'intensité des signaux délivrés par les pixels 108 dépendent donc de la netteté, mais surtout, et principalement, de l'image. Ainsi, en considérant les informations délivrées par les pixels 108, même disposés à différents niveaux, pris isolément les unes des autres, il n'est pas possible de déterminer la distance de l'objet dont l'image est capturée sans autre information.

Le contraste entre pixels voisins d'un même groupe de pixels 108 ne suffit pas non plus à lui seul pour déterminer la distance de l'objet dont l'image est capturée.

En effet, le contraste passe par un extrémum (cas où le point de focalisation se situe au niveau des pixels) et il y a donc, pour une valeur de contraste quelconque différente de cet extrémum, deux valeurs de distance possibles (cas où le point de focalisation se situe devant ou derrière les pixels).

Or, la valeur du contraste varie avec la hauteur de l'ouverture 114, c'est-à-dire l'épaisseur du matériau optiquement transparent 116 traversé. Cette variation est en relation avec la focalisation réalisée par le système optique 150 qui concentre la lumière selon un cône. La variation du contraste en passant d'un niveau à l'autre correspond donc en première approximation à une conique (par exemple voisin d'une hyperbole au carré). Ce type de variation se définit mathématiquement avec 2 ou 3 paramètres. Ainsi, en réalisant les portions de matériau optiquement transparent 116 selon au moins trois épaisseurs différentes, il est possible d'obtenir trois points de mesure de ce contraste à différentes hauteurs, ce qui permet de déterminer ces paramètres et ainsi déterminer la distance de l'extrémum et donc la distance entre l'objet et le système optique 150.

A chaque point de la matrice (coordonnées X, Y) correspond une seule épaisseur de matériau optiquement transparent 116 (coordonnée z du pixel) dans le plan image. On cherche donc à obtenir, pour une limite, les valeurs des contrastes en des points distincts et à déterminer par quelles ouvertures 114 passe la limite et/ou quelles ouvertures 114 sont au voisinage de la limite. Or, du fait que chaque ouverture 114 réalisée à travers la couche opaque 113 laisse passer les rayons vers un groupe d'au moins quatre pixels 108, il est donc possible de déterminer le gradient du contraste mesuré, c'est-à-dire la valeur de plus fort contraste possible entre pixels 108, indépendamment de l'orientation de la zone de contraste vis-à-vis de la forme et la disposition des pixels 108.

La pente du gradient donne la valeur du contraste maximum généré par la limite. L'orientation donne la direction perpendiculaire à la limite. Ainsi, au voisinage de l'ouverture 114, il est possible de choisir deux autres ouvertures 114 de hauteurs différentes, mais ayant la même orientation du contraste, laissant supposer que celui-ci est dépendant de la même limite.

Il existe différents types de limite dans une image :

- la limite entre deux couleurs ou la limite d'une ombre sur une surface,
- la limite d'un objet devant un autre,
- la limite d'un objet masqué par un autre.

Il existe donc différentes stratégies pour déterminer la vrai position (X, Y, Z) des limites puis affecter par interpolation une profondeur aux points (pixels) indéterminés entre ses limites, pour obtenir la « carte de profondeurs » de l'image capturée, c'est-à-dire l'image des distances des différents éléments faisant partie de l'image.

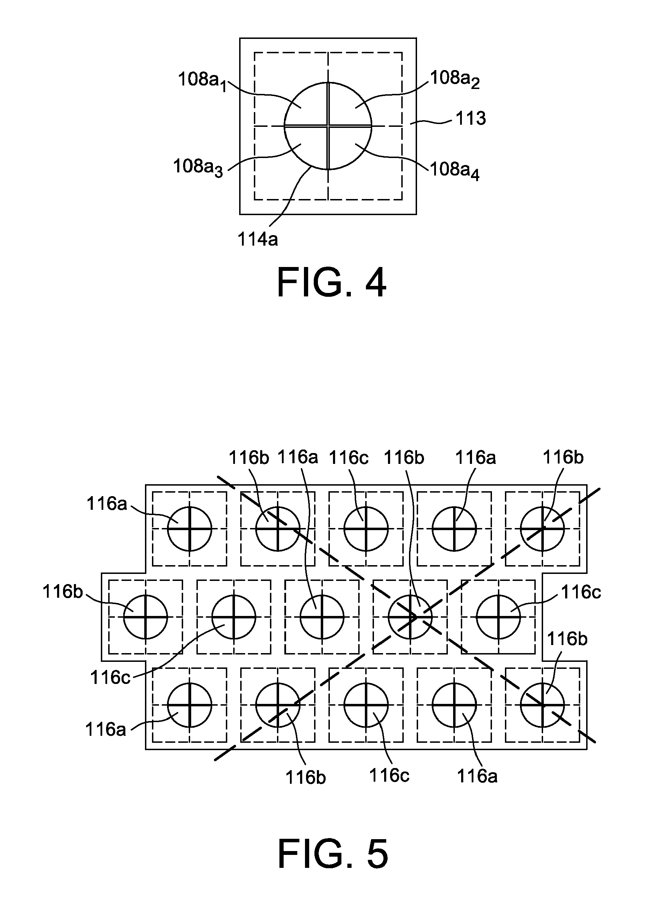

On décrit maintenant un exemple de calculs réalisés permettant de déterminer la distance d'un élément dont l'image est capturée. La figure 4 représente un groupe de quatre pixels $108a_1$-$108a_4$, formant le groupe de quatre pixels se trouvant en regard d'une ouverture 114a et destinée à recevoir des rayons lumineux passant par cette ouverture 114a et traversant une portion 116a de matériau optiquement transparent recouvrant ces quatre pixels identiques $108a_1$-$108a_4$.

Soit a, b, c et d les signaux électriques délivrés par les pixels $108a_1$-$108a_4$.

La pente du gradient du contraste est égale au module $\sqrt{(a-d)^2 + (b-c)^2}$.

La direction du gradient correspond à la phase $\dfrac{a-d}{b-c}$ qui est un angle.

Le contraste n'est pas seulement le module, mais est également indépendant de l'intensité, et est égal à $\dfrac{\sqrt{(a-d)^2 + (b-c)^2}}{a+b+c+d}$.

Afin de déterminer la distance de l'élément capturé, on met en oeuvre un algorithme permettant de déterminer où sont les limites, dont un exemple est décrit ci-dessous. D'autres algorithmes peuvent également être utilisés, par exemple basés sur le principe de démosaïquage des matrices colorées suivi de la détermination de paramètres de la fonction conique.

A partir des équations précédentes, et pour l'ensemble des ouvertures 114, on obtient depuis les signaux des quatre photodétecteurs correspondants, plusieurs tables de valeurs : une pour les directions du gradient, et une autre pour les contrastes (et éventuellement une pour les modules du gradient et une pour l'intensité totale, utilisées pour un autre algorithme).

On créé également une autre table définissant la précision des contrastes (P), vis-à-vis du niveau de bruit des photodétecteurs. Plusieurs critères avec des poids différents peuvent intervenir. Si B est la valeur absolue du niveau de bruit moyen des photodétecteurs et abs() désigne la valeur absolue, on a alors :

$$\left(\frac{abs(a-d)}{2B} + 1\right)\left(\frac{abs(b-c)}{2B} + 1\right) / 4 = P$$

Plus P est grand, plus le contraste est considéré comme précis. Une précision P voisine de 1 pourra être considérée comme mauvaise.

Les contrastes trop imprécis ou trop faibles sont éliminés des futurs calculs par une nouvelle table chargée de mémoriser la validité de la position de l'ouverture 114. Dans ce cas, on rejette la position car on considère qu'elle fait alors partie d'une zone homogène, loin d'une limite dans l'image.

Ensuite pour chaque ouverture restant valide, on détermine une ou plusieurs zones de voisinages (par exemple deux zones). Ces zones n'entourent pas nécessairement l'ouverture considérée, en particulier sur les bords de l'image. La dimension typique de la zone sera de 5x5 ou 6x6 ouvertures 114 valides. Pour améliorer la précision de la détermination, il est possible de considérer plusieurs zones, et leur définir une forme complexe, car une limite dans l'image peut séparer deux objets de distance différente, avec un contraste de la limite variant différemment d'un coté ou de l'autre d'un bord d'objet.

Pour chaque zone de voisinage, les différentes ouvertures 114 restant validées sont classées par direction du gradient relativement à la direction du gradient de l'ouverture 114 considéré. Le critère de classement est donc la valeur absolue de l'écart angulaire du gradient à celui de l'ouverture 114 considérée. De ce classement, on retient les trois ouvertures 114 de niveaux différents ayant le plus petit écart angulaire. Les trois valeurs de contraste de ces trois ouvertures 114 sont ajustées à une fonction de type « conique » pour remonter aux paramètres constants de la fonction. A partir de la fonction et des paramètres ainsi déterminés, on extrait l'extrémum de la fonction correspondant au niveau de focalisation du système optique. De cette position d'extrémum est obtenue la distance de la limite devant l'optique, à partir des lois de l'optique et en tenant compte des caractéristiques de l'optique particulière utilisée.

Les différentes zones de voisinages évaluées autour d'une ouverture 114 donnent en général des distances de l'objet différentes. La zone choisie, et donc la valeur de distance choisie, est soumise a un critère. Il est possible de prendre par exemple comme critère que la somme des distances des ouvertures 114 à la droite perpendiculaire à la pente du contraste de l'ouverture 114 considérée doit être minimale. Des critères plus complexes peuvent être choisis selon l'application.

Enfin, les ouvertures 114 non valides pour ce calcul, car sans contraste, sont, selon les besoins, laissées indéfinies, ou bien leurs distances sont calculées par une méthode d'interpolation.

Les calculs réalisés ici sont des opérations de regroupement d'éléments de table, de tables pour des zones de petite dimension, de tri ou de comparaisons ou de calculs statistiques basiques sur des petits nombres d'éléments. Ces opérations ne nécessitent pas de grosses puissances de calcul.

Dans une variante de réalisation, on peut réaliser un dispositif comportant des portions 116 de plus de trois épaisseurs différentes et/ou plus de quatre pixels associés à chaque portion 116 et chaque ouverture 114.

La répartition des portions de matériau optiquement transparent 116 d'épaisseurs différentes est réalisée de manière sensiblement uniforme pour l'ensemble du dispositif imageur 100. Ainsi, il est avantageux de répartir ces portions de différentes épaisseurs telles que pour chacune des portions de matériau optiquement transparent 116, les portions de matériau optiquement transparent 116 adjacentes comportent des épaisseurs différentes de celle de ladite portion de matériau optiquement transparent 116.

La figure 5 représente un exemple de répartition des portions de matériau optiquement transparent 116a, 116b, 116c d'épaisseurs différentes. Dans cet exemple, les portions 116a, 116b, 116c, et donc également les ouvertures 114a, 114b, 114c, sont disposées en quinconce les unes par rapport aux autres. Chacune de ces portions 116 (ou ouvertures 114) a six portions 116 voisines (ou ouvertures 114 voisines) réparties en formant autour d'elle un hexagone. Dans les trois directions formées par la portion centrale et les portions adjacentes, on trouve bien une alternance de portions 116 des trois épaisseurs différentes $e_1$, $e_2$ et $e_3$, ce qui permet de déterminer par calcul, à partir des signaux délivrés par les pixels 108, les distances selon ces directions. Par contre, selon une verticale ou une bissectrice d'un des cotés de cet hexagone (directions représentées par des pointillés sur la figure 5), les portions de matériau optiquement transparent 116 alignées selon ces directions ont une épaisseur identique, ce qui empêche de déterminer la distance selon ces directions.

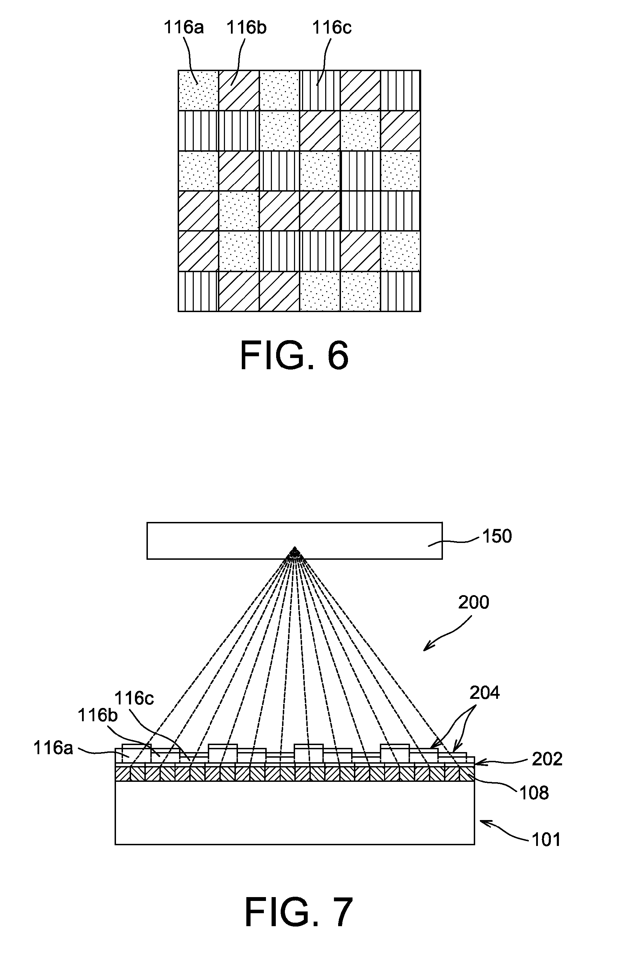

Un second exemple de répartition des portions de matériau optiquement transparent 116a, 116b, 116c sur la matrice de pixels est représenté sur la figure 6. Sur cette figure 6, la répartition est représentée de manière schématique, les carrés dont le motif correspond à des points correspondent aux portions 116a d'épaisseur $e_1$, les carrés dont le motif correspond à des traits obliques correspondent aux portions 116b d'épaisseur $e_2$, et les carrés dont le motif correspond à des traits verticaux correspondent aux portions 116c d'épaisseur $e_3$. Cette répartition des portions 116 d'épaisseurs différentes est telle que si l'on couvre la surface de la matrice de pixels avec une telle disposition, on obtient un pavage pseudo aléatoire réalisé de tel sorte que l'on ne trouve aucun alignement de plus de deux portions d'épaisseur similaire consécutives, quelque soit la direction considérée. On voit sur la figure 6 que le bloc de 6x6 portions 116 représenté comporte un même nombre de chacune des portions 116 d'épaisseurs différentes, c'est-à-dire 12 portions 116a, 12 portions 116b et 12 portions 116c. De plus, selon cette répartition, quelle que soit la direction du plan, il faut au plus 5 pixels pour obtenir un alignement de portions de matériau optiquement transparent 116 comportant au moins une portion 116 de chacune des trois épaisseurs $e_1$, $e_2$ et $e_3$.

Dans le dispositif imageur 100 précédemment décrit, les ouvertures 114 sont espacées les unes des autres d'une distance plus importante que pour les groupes de pixels (les groupes de quatre pixels).

On se réfère à la figure 7 qui représente un dispositif imageur 200 selon un second mode de réalisation.

Comme le dispositif imageur 100 précédemment décrit, le dispositif imageur 200 comporte le système optique 150 et le circuit intégré imageur 101 comprenant notamment la matrice de pixels 108.

Le dispositif imageur 200 comporte également les portions 116 de matériau optiquement transparent d'épaisseurs différentes recouvrant les groupes de quatre pixels.

Le dispositif imageur 200 comporte également des moyens aptes à laisser passer, vis-à-vis de chacun desdits groupes de pixels 108, les rayons lumineux orientés vers ledit groupe de pixels 108 et traversant la portion de matériau optiquement transparent 116 recouvrant ledit groupe de pixels 108, et aptes à bloquer les rayons lumineux orientés vers ledit groupe de pixels 108 et traversant les autres portions de matériau optiquement transparent 116 ne recouvrant pas ledit groupe de pixels 108. Toutefois, contrairement au dispositif imageur 100 dans lequel ces moyens sont formés par la couche opaque 113 et les ouvertures 114, ces moyens sont ici formés par une première matrice de filtres colorés 202 disposés entre la matrice de pixels 108 et les portions de matériau optiquement transparent 116, et une seconde matrice de filtres colorés 204 recouvrant les portions de matériau optiquement transparent 116, chaque filtre de la première matrice 202 recouvrant un desdits groupes de pixels 108 et chaque filtre de la seconde matrice 204 recouvrant une desdites portions de matériau optiquement transparent 116, les spectres d'absorption lumineuse de deux filtres sensiblement superposés de la première et de la seconde matrice étant sensiblement similaires.

Deux filtres colorés sont considérés comme étant sensiblement superposés lorsqu'ils sont alignés selon un axe passant par le centre optique du système optique 150 et le centre du groupe de pixels 108 dont les deux filtres sont destinés à filtrer la lumière entrante.

Par rapport au dispositif imageur 100, le dispositif imageur 200 permet de supprimer l'espacement entre les groupes de pixels 108 qui peuvent être ici adjacents et qui permet, dans le dispositif imageur 100, d'éviter les interférences entre les rayons lumineux capturés par les groupes de pixels adjacents, cette fonction étant ici réalisée par la superposition des deux matrices de filtres colorés. En effet, comme cela est représenté sur la figure 7, dans le dispositif imageur 200, les groupes de pixels 108 (groupes de quatre pixels) peuvent être jointifs.

Dans ce second mode de réalisation, les rayons lumineux passant par un filtre coloré de la seconde matrice 204 ne traversent que le filtre coloré de la première matrice 202 recouvrant le groupe de pixels 108 destiné à recevoir ces rayons lumineux. Pour cela, les spectres d'absorption lumineuse de ces deux filtres colorés sensiblement superposés de la première et de la seconde matrice sont sensiblement similaires. Par contre, les spectres d'absorption lumineuse de deux filtres colorés adjacents d'une même matrice sont différents. En faisant un parallèle entre les dispositifs imageurs 100 et 200, les filtres colorés de la seconde matrice 204 remplissent la même fonction que les ouvertures 114, c'est-à-dire déterminent la taille de l'ouverture par laquelle entrent les rayons lumineux, et les filtres colorés de la première matrice 202 remplissent la fonction de masquage réalisée par les portions de la couche opaque 113.

On réalise de préférence les filtres colorés des matrices 202, 204 tels que l'ensemble des couleurs, par exemple quatre, des filtres colorés soient réparties sur les différentes épaisseurs de matériau optiquement transparent, car la valeur du contraste est dépendante de la couleur. Le calcul de la distance à partir des contrastes dans une même couleur correspond au même calcul que celui fait pour obtenir la distance à partir des ouvertures. Les contrastes entre des couleurs différentes impliquent des ajustements pour le calcul de la distance dépendant du spectre des filtres.

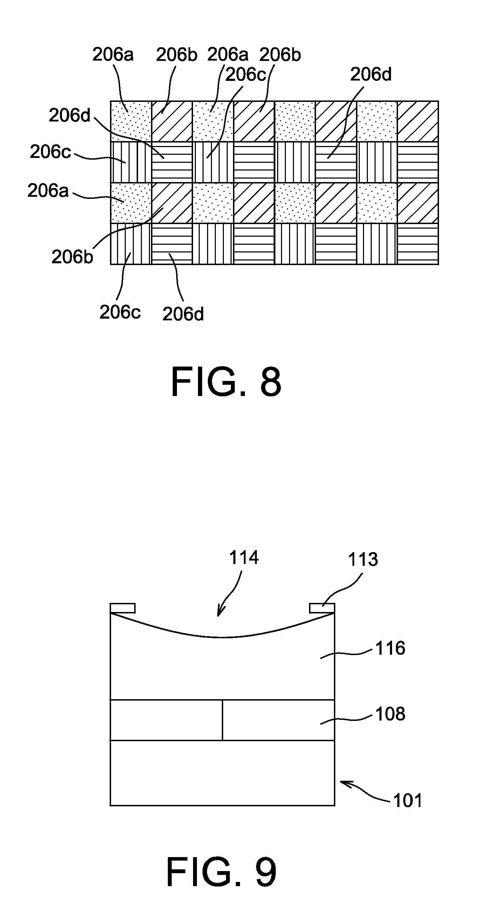

La figure 8 représente un exemple de réalisation des matrices de filtres colorés 202 et 204.

Sur cet exemple, cette matrice est formée par la répétition d'un groupe de quatre filtres 206a, 206b, 206c, 206d disposés en carré. Ainsi, les filtres 206a, 206b, 206c et 206d correspondent respectivement à un filtre vert ou cyan, un filtre jaune, un filtre rouge et un filtre bleu. Ce motif est répété sur l'ensemble du plan du dispositif imageur 200, autant pour la seconde matrice 204 que pour la première matrice 202. Les filtres colorés sont réalisés tels que deux filtres adjacents (aussi bien horizontalement, verticalement mais également en diagonale) soient sans recouvrement de spectres, de telle sorte que la lumière traversant un filtre soit absorbée par les autres filtres qui l'entourent. Certains spectres de deux filtres adjacents peuvent se recouvrir légèrement (par exemple les filtres bleu et vert ou cyan, ou les filtres jaune et rouge) et d'autres non. Quand la surface de recouvrement entre la lumière passant par les filtres de la seconde matrice 204 et arrivant sur les filtres de la première matrice 202 est faible, typiquement le cas des coins des filtres, on peut autoriser un léger recouvrement des spectres. Ainsi, les filtres 206a et 206d, respectivement vert ou cyan et bleu, ainsi que les filtres 206b et 206c, respectivement jaune et rouge, en contact par leurs coins, ont des spectres qui se recouvrent légèrement. Par contre, les filtres jointifs par un bord (deux filtres côte à côte horizontalement ou verticalement) seront réalisés tels que leurs spectres soient séparés le plus possible, comme c'est le cas sur l'exemple de la figure 8.

Dans le dispositif imageur 200, les quatre matrices empilées (matrice de pixels 108, première matrice de filtres colorés 202, seconde matrice de filtres colorés 204, matrice de portions de matériau optiquement transparents 116) obéissent à des lois de répartition différentes. Ainsi, les pixels 108 sont groupés par paire, tandis que les filtres sont réalisés selon un motif formant un masque, et les portions de matériau optiquement transparent 116 sont réalisées selon un autre motif pseudo aléatoire pour éviter les alignements. Les pas de répétition des éléments de ces différentes matrices peuvent être tous différents.

Dans une première variante de réalisation, il est possible de réaliser un dispositif imageur couplant les deux matrices de filtres colorés 202, 204 avec la couche opaque 113 et les ouvertures 114a, 114b, 114c afin de mieux définir les ouvertures et donc mieux sélectionner les rayons lumineux reçus par chaque groupe de pixels.

Dans une autre variante de réalisation, le dispositif imageur peut comporter un circuit intégré imageur comprenant des pixels dits « front-side », la lumière étant dans ce cas destinée à entrer du côté de la face du circuit intégré imageur comportant les lignes d'interconnexions électriques avant d'atteindre les pixels. Dans ce cas, les pixels seront de préférence réalisés tels que pour chaque groupe de quatre pixels, les quatre photodiodes de ces quatre pixels seront disposées sous une même ouverture de manière jointive et les interconnexions seront réalisées autour de l'ensemble des quatre photodiodes.

Quelque soit le mode de réalisation du dispositif imageur, il est possible que celui-ci comporte des micro-lentilles, identiques ou non, disposées sur les ouvertures 114 ou sur les filtres colorés 204. Du fait que l'ajout de ces micro-lentilles permet de mieux guider les rayons lumineux vers les pixels 108, il est possible de réduire les épaisseurs des portions de matériau optiquement transparent 116 (tout en ayant des portions d'épaisseurs différentes), facilitant leur réalisation. De plus, ces micro-lentilles permettent également de réduire les réflexions des rayons lumineux dans le circuit intégré imageur.

Ces micro-lentilles sont plus courbées que l'onde issue du système optique 150. Du fait de sa forte courbure, ces micro-lentilles agissent comme des réducteurs de focale. Au contraire, dans le cas d'un système optique 150 très ouvert, les micro-lentilles ont une courbure inférieure à l'onde issue du système optique 150, permettant ainsi de « redresser » les rayons lumineux, et agissent par un allongement de focale. Dans ce dernier cas, les couches 116 sont plus épaisses. Les rayons lumineux sont donc moins obliques, ce qui permet de réduire les réflexions aux différentes interfaces. Il est également possible d'utiliser des micro-lentilles en bosses qui permettent de réduire l'épaisseur des couches 116 par rapport à des micro-lentilles en creux.

Dans une autre variante, il est possible de réaliser les surfaces des portions de matériau optiquement transparent 116 qui sont au niveau des ouvertures 114 telles qu'elles forment, au niveau de chaque ouverture 114, un dioptre en creux, permettant de mieux séparer les différentes focales par une réfraction accentuée. La figure 9 représente une portion de matériau optiquement transparent 116 selon cette variante.

Dans une autre variante, le dispositif imageur peut comporter plusieurs couches opaques comportant des ouvertures 114 et/ou plus de deux matrices de filtres colorés superposées, ce qui permettant d'améliorer l'ajustement des niveaux ou les signaux entre ces différents niveaux.

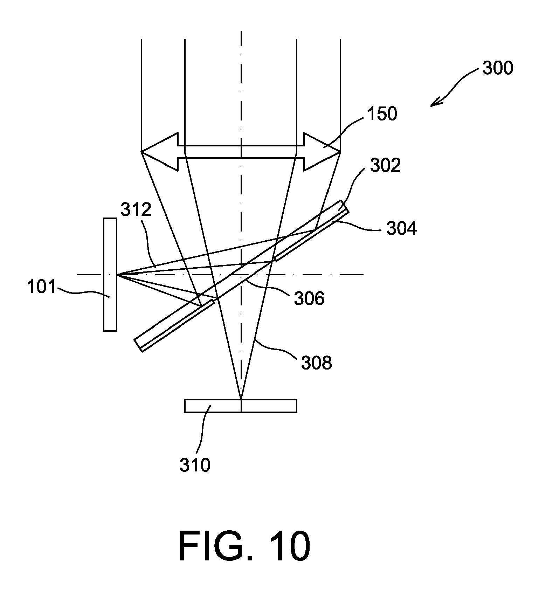

On se réfère à la figure 10 qui représente un dispositif imageur 300 selon un troisième mode de réalisation. Contrairement aux précédents modes de réalisation, les rayons lumineux issus du système optique 150 ne sont pas envoyés directement vers les pixels 108 du circuit intégré imageur 101. En effet, dans le dispositif imageur 300, les rayons lumineux issus du système optique 150 sont envoyés vers une lame séparatrice 302 couplée à un miroir 304. Le miroir 304 comporte une zone centrale 306 formée d'une ouverture, par exemple elliptique, permettant de laisser passer une partie des rayons lumineux. Les rayons lumineux issus du système optique 150 arrivent au niveau de la lame séparatrice 302 et du miroir 304 en formant un angle par exemple égal à 45° (cet angle correspondant à l'angle formé entre l'axe optique du système optique 150 et l'axe optique de la lame séparatrice 302 et du miroir 304). Ainsi, les rayons lumineux centraux 308 traversent la lame séparatrice 302 et le miroir 304 par la zone centrale 306 et atteignent un circuit intégré imageur classique 310. Par contre, les rayons lumineux périphériques 312 issus du système optique 150 sont reflétés par le miroir 304 et envoyés vers le circuit intégré imageur 101 qui est couplé par exemple aux portions de matériau optiquement transparent 116 et à la couche opaque 113 et/ou aux filtre colorés 202, 204 tel que précédemment décrits.

On obtient ainsi simultanément une image classique à partir du circuit intégré imageur 310 et une image permettant de déterminer la distance des éléments de l'image capturée. La lame séparatrice 302 permet de modifier progressivement le coefficient de transmission/réflexion en bordure de l'ouverture elliptique 306.

La réalisation des portions de matériau optiquement transparent 116, de la couche opaque 113, des ouvertures 114 ou encore des filtres colorés 202, 204 se fait dans ou à la suite de la réalisation du circuit intégré imageur 101. Les étapes supplémentaires sont de même nature (dépôt photolithographie, gravure) que celles mises en oeuvre pour la réalisation du circuit intégré imageur 101. Plus particulièrement, les portions 116 de matériau optiquement transparent peuvent être obtenues par des dépôts successifs de couches uniformes, de photolithographie et de gravure de ces couches.

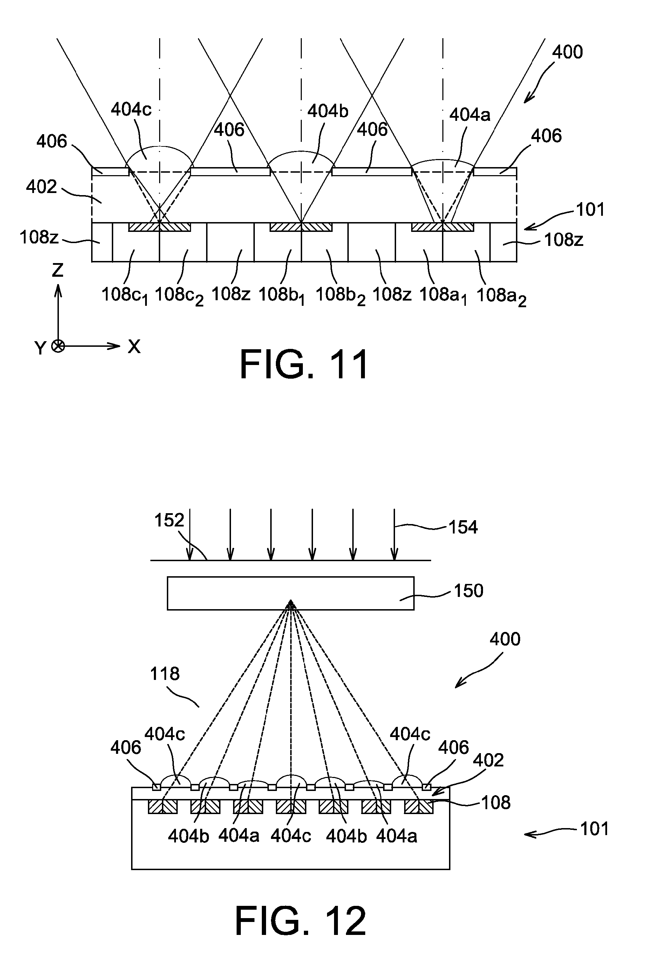

On se réfère aux figures 11 et 12 qui représentent partiellement et schématiquement un dispositif imageur 400 selon un quatrième mode de réalisation.

Comme dans les dispositifs imageurs précédemment décrits, le dispositif imageur 400 comporte le circuit intégré imageur 101 comprenant notamment la matrice de pixels 108. La matrice de pixels 108 est recouverte par une couche 402 de matériau optiquement transparent d'épaisseur sensiblement uniforme.

Comme les précédents dispositifs imageurs 100, 200 et 300 dans lesquels les portions de matériau optiquement transparent 116 réalisent une fonction de focalisation à différents niveaux des rayons lumineux sur les pixels, le dispositif imageur 400 comporte également des moyens de focalisation permettant de focaliser les rayons lumineux vers des groupes de quatre pixels à différents niveaux, c'est-à-dire réalisant des focalisations équivalentes à une disposition des groupes de pixels associés à trois distances différentes vis-à-vis de la face d'entrée des rayons lumineux dans le dispositif imageur 400. Ces moyens de focalisation correspondent à des lentilles, ou micro-lentilles, 404 disposées sur la couche transparente 402. Le dispositif imageur 400 comporte trois types de lentilles différentes réalisant des focalisations et des convergences différentes. Sur l'exemple de la figure 11 (sur laquelle seulement une partie du dispositif imageur 400 est représentée), une première lentille 404a réalise une focalisation de rayons lumineux sur un premier groupe de quatre pixels dont font partie les pixels $108a_1$ et $108a_2$. La focalisation réalisée par la première lentille 404a est par exemple équivalente à celle réalisée par la portion de matériau optiquement transparente 116a du dispositif imageur 100 représenté sur la figure 3. Une deuxième lentille 404b réalise une focalisation de rayons lumineux sur un deuxième groupe de quatre pixels dont font partie les pixels $108b_1$ et $108b_2$, et la focalisation réalisée par cette deuxième lentille 404b est par exemple équivalente à celle réalisée par la portion de matériau optiquement transparente 116b du dispositif imageur 100 de la figure 3. Enfin, une troisième lentille 404c réalise une focalisation de rayons lumineux sur un troisième groupe de quatre pixels dont font partie les pixels $108c_1$ et $108c_2$. La focalisation réalisée par la lentille 404c est par exemple équivalente à celle réalisé par la portion de matériau optiquement transparente 116c du dispositif imageur 100 représenté sur la figure 3.

L'épaisseur de la couche transparente 402 est choisie en fonction de la distance souhaitée entre les lentilles 404 et la matrice de pixels 108, en fonction des focalisations souhaitées qui seront réalisées par les lentilles 404 et en fonction de l'indice optique des matériaux. L'épaisseur de la couche transparente 402 est par exemple comprise entre environ 1 μm et 20 μm, et/ou par exemple comprise entre 1 et 4 fois la largeur d'un pixel. On voit sur les figures 11 et 12 que la courbure des lentilles 404c est plus importante que celle des lentilles 404b, qui elles-mêmes ont une courbure plus importante que celle des lentilles 404a. Ces différentes courbures permettent d'obtenir des focalisations différentes entre ces différents types de lentilles.

Le dispositif imageur 400 comporte également le système optique 150 (représenté sur la figure 12) guidant les rayons lumineux 154 issus d'une scène vers la matrice de pixels 108, les rayons lumineux 154 entrant dans le dispositif imageur 400 par la face d'entrée 152 du dispositif imageur 400. Comme dans les dispositifs imageurs précédemment décrits, une image avec des zones nettes et des zones floues est donc formée sur la matrice de pixels 108.

Des portions de matériau opaque 406 sont disposées entre les lentilles 404. Ces portions opaques 406 remplissent la même fonction que le masque 113 du dispositif imageur 100, c'est-à-dire permettent de bloquer les rayons lumineux qui sont orientés vers un des groupes de pixels 108 mais qui traversent une lentille autre que celle associée au dit groupe de pixels. La lumière passant par une des lentilles 404, mais qui serait mal focalisée, ne peut donc pas atteindre le groupe de pixels se trouvant sous une lentille voisine.

Le dispositif imageur 400 comporte trois types de lentilles différentes 404 dont les vergences sont différentes. Les différences de vergence entre les lentilles 404 et les différences entre les signaux délivrés par les pixels d'un même groupe de quatre pixels permettent de remonter par calcul aux contours des objets dans l'image capturée et à la distance des objets de la scène, en une seule capture d'image et sans l'aide de sources de lumière extérieures additionnelles, ni modification particulière du système optique utilisé pour guider les rayons lumineux vers le circuit intégré imageur, par rapport à un dispositif imageur classique.

Comme cela est visible sur la figure 12, les lentilles 404 sont légèrement décalées pour être centrées sur l'axe joignant le centre optique du système optique convergent principal 150 au centre des de la matrice 2x2 formée par le groupe de quatre pixels associés. Cet axe correspond à l'axe optique de la lentille. Les photodétecteurs des pixels de chaque groupe de pixels sont disposés tout autour de l'axe optique de la lentille associée au groupe de pixels. Il existe un pas constant entre les lentilles et ce pas diffère de celui des groupes de quatre pixels associés. De plus, comme représenté sur la figure 12, tous les groupes de quatre pixels ont des axes optiques d'inclinaison différente.

Un choix de convergence particulier des lentilles 404 est tel que les lentilles de courbure moyenne (celle des lentilles 404b sur l'exemple des figures 11 et 12) ne dévie pas la trajectoire des rayons provenant du système optique 150. Pour cela, ces lentilles 404b correspondent par exemple à des portions de sphère dont les centres se situent au niveau de la face supérieure de la matrice de pixels 108, par exemple au niveau des centres des groupes de pixels 108 associés se trouvant sous ces lentilles. Dans ces conditions, les lentilles 404b n'influent pas sur la focalisation des rayons lumineux dirigés vers les groupes de pixels correspondant (dont font partie les pixels $108b_1$ et $108b_2$ représentés sur la figure 11). Dans ces conditions, les lentilles de plus forte courbure (lentilles 404c) font converger les rayons plus fortement et produisent une image nette devant les pixels 108 (une image floue sera donc formée sur les pixels 108), et les lentilles de plus faible courbure (lentilles 404a) font légèrement diverger les rayons et repoussent l'image nette derrière (ou à l'intérieur) des pixels 108, une image floue étant également formée sur les pixels 108.

Les focalisations des trois types de lentilles 404 sont équivalentes à trois positions différentes de mise au point du système optique 150, c'est-à-dire une disposition des groupes de pixels associés à trois distances différentes vis-à-vis de la face d'entrée des rayons lumineux dans le dispositif imageur.

Les calculs réalisés à partir des signaux délivrés par les pixels 108 du dispositif imageur 400 afin d'obtenir une carte de profondeur sont similaires à ceux précédemment réalisés pour les précédents dispositifs imageurs 100 à 300. De plus, les différentes répartitions possibles des pixels précédemment décrites en liaison avec la figure 5, et de préférence avec la figure 6, s'appliquent également au dispositif imageur 400.

Par rapport au dispositif imageur 100 précédemment décrit, l'utilisation de lentilles de différentes convergences pour réaliser les moyens de focalisation permet, par rapport à l'utilisation de portions de matériau optiquement transparent d'épaisseurs différentes, de réduire l'espace nécessaire autour des groupes de pixels (c'est-à-dire les dimensions des portions opaques 406 par rapport aux dimensions des portions du masque 113 du dispositif imageur 100).

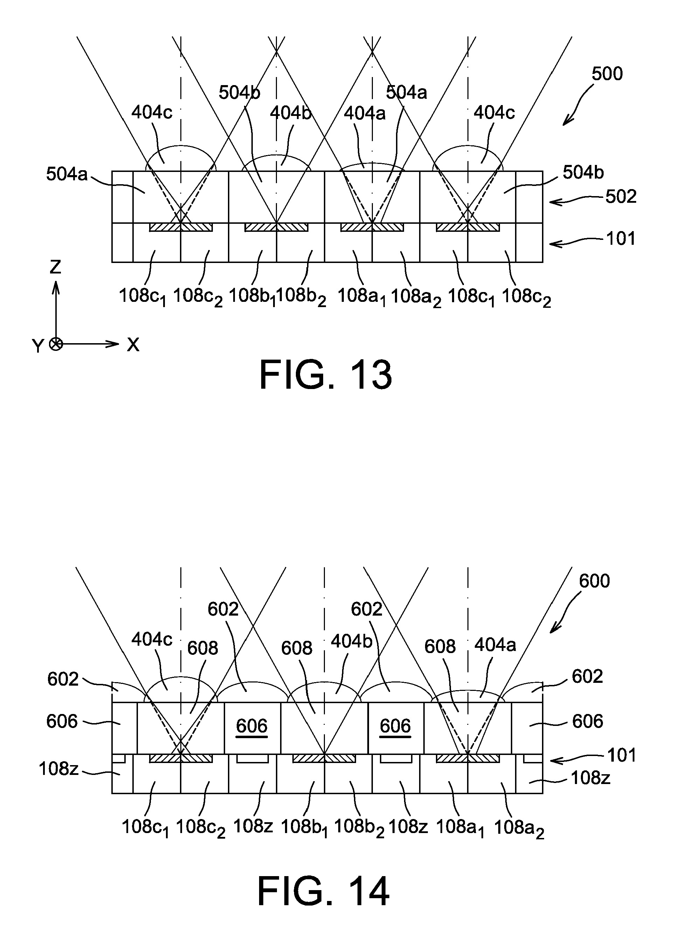

De manière analogue au dispositif imageur 200, il est possible d'utiliser, à la place des portions opaques 406, des filtres optiques pour bloquer ou non les rayons lumineux dirigés vers les pixels 108. La figure 13 représente partiellement et schématiquement un dispositif imageur 500 selon un cinquième mode de réalisation.

Comme le dispositif imageur 400, le dispositif imageur 500 comporte des lentilles, ou micro-lentilles, 404 (trois types différents référencés 404a, 404b et 404c) réalisant des focalisations différentes des rayons lumineux sur la matrice de pixels 108. Toutefois, contrairement au dispositif imageur 400, le dispositif imageur 500 ne comporte pas de portions de matériau opaque disposées entre les lentilles 404. La fonction de sélection des rayons lumineux devant ou non atteindre les groupe de pixels 108 est ici réalisée par une matrice de filtres colorés 502 disposée entre la matrice de pixels 108 et les lentilles 404, à la place de la couche transparente 402 du dispositif imageur 400. Afin d'éviter que des rayons lumineux ne traversent plusieurs filtres colorés, les spectres d'absorption lumineuse des filtres colorés adjacents (par exemple les filtres 504a et 504b) sont choisis tels qu'ils se chevauchent le moins possible.

Contrairement au dispositif imageur 400, on voit que les groupes de quatre pixels sont ici disposés les uns à côté des autres de manière jointive, sans la présence de pixels 108z entre les groupes de pixels. On améliore ainsi la résolution du dispositif imageur.

Sur l'exemple de la figure 13, la matrice de filtres 502 ne comporte des filtres que de deux couleurs (les filtres 504a correspondent par exemple à des filtres de couleur bleu et les filtres 504b correspondent par exemple à des filtres de couleur rouge) disposés alternativement selon une direction (direction parallèle à l'axe X sur l'exemple de la figure 13). Pour obtenir à la fois une carte de profondeur et une image sans couleur (noir et blanc), il suffit de faire la même chose dans l'autre direction, c'est-à-dire alterner les couleurs des filtres selon la direction parallèle à l'axe Y. L'effet de masquage obtenu est alors suffisant. Les espaces entre les lentilles 404 sont réduits au minimum pour un meilleur signal, mais ils peuvent tout de même exister. Néanmoins, une précaution peut être prise au moment du calcul pour tenir compte d'une influence de la couleur sur le contraste. Les lentilles choisies pour les trois signaux de contraste peuvent être sur la même couleur. Il est également possible de tenir compte de l'écart en appliquant un facteur de correction préalablement déterminé entre couleurs et éventuellement fonction de l'intensité des signaux a+b+c+d (signaux correspondant à ceux des quatre pixels précédemment décrits en liaison avec la figure 4).

Pour réaliser à la fois une capture d'une image couleur classique et une carte de profondeur, on fait appel à des filtres de plus de deux couleurs. Il est préférable que dans chacune des couleurs (les filtres de la matrice de filtres colorés 502 peuvent être répartis conformément à l'exemple précédemment décrit en liaison avec la figure 8), les trois types de convergences existent, car la valeur du contraste est dépendante de la couleur. La détermination des contrastes dans une même couleur correspond au même calcul que celui réalisé pour le dispositif imageur 400. Les contrastes entre des couleurs différentes peuvent demander de faire des ajustements dépendant du spectre des filtres, comme précédemment décrit.

L'utilisation combinée de la matrice de filtres colorés 502 et des lentilles 404 permet de réduire l'interaction des rayons lumineux entre les groupes de pixels voisins, c'est-à-dire réduire la transmission parasite de rayons lumineux d'un groupe de pixels à un groupe de pixels voisin.

Dans une variante de ce cinquième mode de réalisation, le dispositif imageur 500 pourrait comporter des portions de matériau opaque, analogues aux portions 406 du dispositif imageur 400, disposées entre les lentilles 404, afin d'améliorer la sélection des rayons lumineux reçus par les groupes de pixels.

La figure 14 représente schématiquement et partiellement un dispositif imageur 600 selon un sixième mode de réalisation. Ce dispositif imageur 600 permet de réaliser une capture d'image en couleur et, simultanément, une capture d'image permettant de calculer une carte de profondeur.

Comme pour le dispositif imageur 400 précédemment décrit, le dispositif imageur 600 comporte un circuit intégré 101 comprenant notamment une matrice de pixels 108. Le dispositif imageur 600 comporte également les trois types de lentilles 404a, 404b, 404c disposées en regard de groupes de quatre pixels 108. Ces groupes de pixels (dont font partie les pixels référencés $108a_1$, $108a_2$, $108b_1$, $108b_2$, $108c_1$ et $108c_2$) sont espacés les uns des autres par les pixels 108z. Des lentilles 602 recouvrent les pixels 108z destinés à réaliser la capture d'images en couleur classique. Ces lentilles 602 sont par exemple similaires aux lentilles 404b, c'est-à-dire ne dévient pas la trajectoire des rayons provenant du système optique 150 (non représenté sur la figure 14). L'image couleur traditionnelle est donc obtenue à partie des signaux délivrés par les pixels 108z. Des filtres colorés 606, formant par exemple un filtre de Bayer, sont disposés entre les lentilles 602 et les pixels 108a.

Les lentilles 404 sont disposées sur des filtres 608 dont le spectre d'absorption lumineuse est différent de celui des filtres 606, n'absorbant par exemple que les longueurs d'ondes du domaine infrarouge ou ultraviolet. On évite ainsi un recouvrement entre les rayons lumineux traversant les filtres colorés 606, destinés à la capture d'image en couleur, et les filtres 608 destinés filtrer les rayons qui seront capturés par les pixels qui délivreront des signaux électriques servant au calcul de la carte de profondeur.

Les dispositifs imageurs précédemment décrits serviront avantageusement dans des équipements de mesure et de contrôle industriel, des équipements interactifs tels que téléphones et ordinateurs faisant appel à la réalité augmentée, des équipements de sécurité dans les véhicules, par exemple dans des systèmes anticollision automobile, ou d'aide a la conduite. Les dispositifs imageurs pourront servir également en complément de photos et films stéréoscopiques pour permettre de réaliser des effets spéciaux, ou encore pour former un système de détection d'approche.

**Revendications**

1. Dispositif imageur (100 - 600) comportant au moins :

   - un circuit intégré imageur (101) comprenant une matrice de pixels (108) destinés à recevoir des rayons lumineux (154) issus d'une scène,
   - plusieurs premiers (116a, 404a), deuxièmes (116b, 404b) et troisièmes (116c, 404c) moyens de focalisation disposés les uns à côté des autres sur la matrice de pixels (108), entre la matrice de pixels (108) et une face d'entrée (152) des rayons lumineux (154) dans le dispositif imageur (100 - 600), tels que chacun desdits moyens de focalisation (116, 404) soit disposé en regard d'un groupe d'au moins quatre desdits pixels (108) associés au dit moyen de focalisation (116, 404) et formant une matrice 2x2, et soit apte à réaliser une focalisation d'une partie des rayons lumineux vers ledit groupe de pixels associés, **caractérisé en ce que** les focalisations réalisées par les premiers, deuxièmes et troisièmes moyens de focalisation (116, 404) étant différentes les unes par rapport aux autres et équivalentes à une disposition des groupes de pixels associés à trois distances différentes vis-à-vis de la face d'entrée (152) des rayons lumineux dans le dispositif imageur (100 - 600), - des quatrièmes moyens (113, 114, 202, 204, 406, 504, 608) aptes à laisser passer, vis-à-vis de chaque groupe de pixels (108), les rayons lumineux orientés vers ledit groupe de pixels (108) et traversant le moyen de focalisation (116, 404) associé au dit groupe de pixels (108), et aptes à bloquer les rayons lumineux orientés vers ledit groupe de pixels (108) et traversant les autres moyens de focalisation (116, 404).

2. Dispositif imageur (100 - 600) selon la revendication 1, comportant en outre des moyens de calcul aptes à calculer, à partir de signaux électriques délivrés par les pixels (108), une distance entre le dispositif imageur (100, 200, 300) et au moins un élément de la scène.

3. Dispositif imageur (100 - 300) selon l'une des revendications précédentes, dans lequel chacun des premiers, deuxièmes et troisièmes moyens de focalisation (116) comporte respectivement une première (116a), une deuxième (116b) et une troisième (116c) portion d'au moins un matériau optiquement transparent d'épaisseurs $e_1$, $e_2$ et $e_3$ non nulles et telles que $e_1 > e_2 > e_3$, et dans lequel l'indice de réfraction du matériau optiquement transparent est différent de l'indice de réfraction d'au moins un matériau et/ou un gaz (118) présent entre la face d'entrée (152) des rayons lumineux (154) et les moyens de focalisation (116).

4. Dispositif imageur (100 - 300) selon la revendication 3, dans lequel, pour chacune des portions de matériau optiquement transparent (116a, 116b, 116c), au moins deux des portions de matériau optiquement transparent adjacentes comportent des épaisseurs différentes de celle de ladite portion de matériau optiquement transparent.

5. Dispositif imageur (100, 300) selon l'une des revendications 3 ou 4, dans lequel les quatrièmes moyens comportent au moins une couche opaque (113) recouvrant les portions de matériau optiquement transparent (116) et qui est traversée par une pluralité d'ouvertures (114) formant chacune, vis-à-vis de chacun desdits groupes de pixels (108), un diaphragme.

6. Dispositif imageur (100, 300) selon la revendication 5, dans lequel chaque ouverture (114) comporte, dans un plan parallèle à la face d'entrée (152) des rayons lumineux (154) dans le dispositif imageur (100, 300), une section sensiblement circulaire, et/ou dans lequel le centre de chaque ouverture (114) est espacée du centre d'une ouverture (114) voisine d'une distance supérieure à environ deux fois une dimension d'un pixel (108), et/ou dans lequel chaque ouverture (114) présente des dimensions inférieures à celles d'un desdits groupes de quatre pixels (108), et/ou dans lequel chaque ouverture (114) est sensiblement centrée en regard d'une limite entre deux pixels adjacents (108).

7. Dispositif imageur (100 - 300) selon l'une des revendications 3 à 6, comportant en outre un système optique (150) apte à guider les rayons lumineux (154) issus de la scène vers la matrice de pixels (108).

8. Dispositif imageur (100, 300) selon les revendications 5 et 7, dans lequel chaque ouverture (114) est centrée par rapport à une droite passant par le centre optique du système optique (150) et le centre du groupe de pixels (108) dont l'ouverture (114) forme un diaphragme.

9. Dispositif imageur (200, 300) selon l'une de revendications 3 à 8, dans lequel les quatrièmes moyens comportent une première matrice de filtres colorés (202) disposés entre la matrice de pixels (108) et les portions de matériau optiquement transparent (116), et une seconde matrice de filtres colorés (204) recouvrant les portions de matériau optiquement transparent (116), chaque filtre de la première matrice (202) recouvrant un desdits groupes de pixels (108) et chaque filtre de la seconde matrice (204) recouvrant une desdites portions de matériau optiquement transparent (116), les spectres d'absorption lumineuse de deux filtres colorés sensiblement superposés de la première (202) et de la seconde matrice (204) étant sensiblement similaires.

10. Dispositif imageur (200, 300) selon la revendication 9, dans lequel la première (202) et/ou la seconde matrice (204) de filtres colorés comporte des premiers (206a), deuxièmes (206b), troisièmes (206c) et quatrièmes (206d) filtres colorés comprenant des spectres d'absorption lumineuse différents.

11. Dispositif imageur (100 - 300) selon l'une des revendications 3 à 10, dans lequel au moins une partie des portions de matériau optiquement transparent (116a, 116b, 116c) comportent une surface d'entrée des rayons lumineux formant un dioptre en creux.

12. Dispositif imageur (400 - 600) selon l'une des revendications précédentes, dans lequel chacun des premiers, deuxièmes et troisièmes moyens de focalisation (404) comporte respectivement une première (404a), une deuxième (404b) et une troisième (404c) lentille de convergences différentes.

13. Dispositif imageur (400) selon la revendication 12, dans lequel les quatrièmes moyens comportent des portions de matériau opaque (406) disposées entre les lentilles (404).

14. Dispositif imageur (400) selon l'une des revendications 12 ou 13, comportant en outre au moins une couche de matériau optiquement transparent (402) disposée entre la matrice de pixels (108) et les lentilles (404).

15. Dispositif imageur (400 - 600) selon l'une des revendications 12 à 14, dans lequel les premières ou les deuxièmes ou les troisièmes lentilles (404b) correspondent à des portions de sphères dont les centres correspondent sensiblement aux centres des groupes de pixels (108) associés auxdites lentilles (404b).

16. Dispositif imageur (500) selon l'une des revendications 12 à 15, dans lequel les quatrièmes moyens comportent une matrice de filtres optiques (502) disposés entre la matrice de pixels (108) et les lentilles (404), chaque filtre optique de la matrice (502) recouvrant un desdits groupes de pixels (108), les spectres d'absorption lumineuse de deux filtres optiques adjacents étant différents.

17. Dispositif imageur (600) selon l'une des revendications 12 à 15, dans lequel les quatrièmes moyens comportent :

   - des premiers filtres optiques (608) dont les spectres d'absorption lumineuse coupent les longueurs d'ondes dans le domaine visible et laissent passer au moins une partie des longueurs d'ondes du domaine infrarouge et/ou ultraviolet, chaque premier filtre optique (608) étant disposé entre une lentille (404) et le groupe de pixels (108) associés à ladite lentille (404),
   - des deuxièmes filtres optiques (606) dont les spectres d'absorption lumineuse laissent passer une partie des longueurs d'ondes du domaine visible et coupent les longueurs d'ondes du domaine infrarouge et ultraviolet,

   les premiers (608) et deuxièmes filtres optiques (606) étant disposés de manière alternés au sein d'une même matrice de filtres optiques disposée entre la matrice de pixels (108) et les lentilles (404).

18. Dispositif imageur (400 - 600) selon l'une des revendications 12 à 17, comportant en outre un système optique (150) apte guider les rayons lumineux (154) issus de la scène vers la matrice de pixels (108).

19. Dispositif imageur (400 - 600) selon la revendication 18, dans lequel chaque lentille (404) est centrée par rapport à une droite passant par le centre optique du système optique (150) et le centre du groupe de pixels (108) associés à ladite lentille (404).

20. Dispositif imageur (100 - 600) selon l'une des revendications 7, 8, 18 ou 19, dans lequel le système optique (150) est couplé à au moins un miroir (304) comprenant au moins un trou (306) tel qu'une première partie (312) des rayons lumineux soient reflétés vers ledit circuit intégré imageur (101) par les parties du miroir (304) périphériques au trou (306) et qu'une seconde partie (308) des rayons lumineux soient guidés vers un autre circuit intégré imageur (310) à travers le trou (306).

21. Dispositif imageur (100 - 600) selon l'une des revendications précédentes, dans lequel les moyens de focalisation (116, 404) sont disposés en quinconce les uns par rapport aux autres.

22. Dispositif imageur (100 - 600) selon l'une des revendications 1 à 20, dans lequel les moyens de focalisation (116, 404) sont disposés sous la forme d'une matrice telle que chaque groupe de cinq moyens de focalisation (116, 404) alignés comporte au moins un de chacun des premiers, deuxièmes et troisièmes moyens de focalisation.

23. Dispositif imageur (100 - 600) selon l'une des revendications précédentes, dans lequel des lignes d'interconnexions électriques (104) reliées électriquement à des photodétecteurs des pixels (108) sont disposées en périphérie desdits groupes de pixels (108).

**Patentansprüche**

1. Abbildungsvorrichtung (100 - 600), die zumindest enthält:

   - einen Abbildungsschaltkreis (101) mit einer Matrix aus Pixeln (108), die dazu bestimmt sind, aus einer Szenerie stammende Lichtstrahlen (154) aufzunehmen,
   - mehrere erste (116a, 404a), zweite (116b, 404b) und dritte (116c, 404c) Fokussierungsmittel, die auf der Pixelmatrix (108) zwischen der Pixelmatrix (108) und einer Eintrittsfläche (152) zum Eintritt der Lichtstrahlen (154) in die Abbildungsvorrichtung (100 - 600) so nebeneinander angeordnet sind, dass jedes der Fokussierungsmittel (116, 404) einer Gruppe von zumindest vier Pixeln (108) gegenüberliegt, die dem Fokussierungsmittel (116, 404) zugeordnet sind und eine 2x2 - Matrix bilden, und dazu geeignet ist, eine Fokussierung eines Teils der Lichtstrahlen zu der Gruppe von zugeordneten Pixeln vorzunehmen,

**dadurch gekennzeichnet, dass**

die von den ersten, zweiten und dritten Fokussierungsmitten (116, 404) vorgenommenen Fokussierungen sich voneinander unterscheiden und äquivalent sind zu einer Anordnung der Gruppen von zugeordneten Pixeln in drei unterschiedlichen Abständen bezüglich der Eintrittsfläche (152) zum Eintritt der Lichtstrahlen in die Abbildungsvorrichtung (100 - 600),

- vierte Mittel (113, 114, 202, 204, 406, 504, 608) dazu geeignet sind, gegenüber jeder Gruppe von Pixeln (108) die Lichtstrahlen durchtreten zu lassen, die zu der Gruppe von Pixeln (108) gerichtet sind und durch das Fokussierungsmittel (116, 404) treten, das der Gruppe von Pixeln (108) zugeordnet ist, und die dazu geeignet sind, die Lichtstrahlen zu blockieren, die zur Gruppe von Pixeln (108) gerichtet sind und durch die weiteren Fokussierungsmitteln (116, 404) treten.

2. Abbildungsvorrichtung (100 - 600) nach Anspruch 1, ferner enthaltend Rechenmittel, die dazu geeignet sind, ausgehend von elektrischen Signalen, die von den Pixeln (108) ausgegeben werden, einen Abstand zwischen der Abbildungsvorrichtung (100, 200, 300) und zumindest einem Element der Szenerie zu berechnen.

3. Abbildungsvorrichtung (100 - 300) nach einem der vorangehenden Ansprüche, wobei jedes der ersten, zweiten und dritten Fokussierungsmittel (116) einen ersten (116a), einen zweiten (116b) bzw. einen dritten Abschnitt (116c) aus zumindest einem optisch transparenten Material mit den Dicken $e_1$, $e_2$ und $e_3$ ungleich null, so dass $e_1 > e_2 > e_3$, aufweist, und wobei der Brechungsindex des optisch transparenten Materials sich von dem Brechungsindex zumindest eines Materials und/oder eines Gases (118) unterscheidet, das zwischen der Eintrittsfläche (152) zum Eintritt der Lichtstrahlen (154) und dem Fokussierungsmitteln (116) vorhanden ist.

4. Abbildungsvorrichtung (100 - 300) nach Anspruch 3, wobei bei jedem der Abschnitte des optisch transparenten Materials (116a, 116b, 116c) zumindest zwei der aneinandergrenzenden Abschnitte aus optisch transparentem Material Dicken aufweisen, die sich von der des genannten Abschnitts aus optisch transparentem Material unterscheiden.

5. Abbildungsvorrichtung (100, 300) nach einem der Ansprüche 3 oder 4, wobei die vierten Mittel zumindest eine lichtundurchlässige Schicht (113) aufweisen, welche die Abschnitte aus optisch transparentem Material (116) bedeckt und von einer Mehrzahl von Aperturen (114) durchsetzt wird, die jeweils eine Aperturblende gegenüber jeder der Gruppen von Pixeln (108) bilden.

6. Abbildungsvorrichtung (100, 300) nach Anspruch 5, wobei jede Apertur (114) in einer Ebene parallel zur Eintrittsfläche (152) zum Eintritt der Lichtstrahlen (154) in die Abbildungsvorrichtung (100, 300) einen im Wesentlichen kreisförmigen Querschnitt hat und/oder wobei der Mittelpunkt einer jeden Apertur (114) von dem Mittelpunkt einer benachbarten Apertur (114) um einen Abstand entfernt liegt, der größer als etwa das Zweifache einer Abmessung eines Pixels (108) ist, und/oder wobei jede Apertur (114) Abmessungen hat, die kleiner als die einer der Gruppen von vier Pixeln (108) ist, und/oder wobei jede Apertur (114) gegenüber einer Grenze zwischen zwei aneinandergrenzenden Pixeln (108) im Wesentlichen zentriert ist.

7. Abbildungsvorrichtung (100 - 300) nach einem der Ansprüche 3 bis 6, ferner enthaltend ein optisches System (150), das dazu geeignet ist, die aus der Szenerie stammenden Lichtstrahlen (154) zur Pixelmatrix (108) zu leiten.

8. Abbildungsvorrichtung (100, 300) nach den Ansprüchen 5 und 7, wobei jede Apertur (114) gegenüber einer Geraden zentriert ist, die durch den optischen Mittelpunkt des optischen Systems (150) und durch den Mittelpunkt der Gruppe von Pixeln (108) verläuft, deren Apertur (114) eine Blende bildet.

9. Abbildungsvorrichtung (200, 300) nach einem der Ansprüche 3 bis 8, wobei die vierten Mittel eine erste Matrix aus Farbfiltern (202) aufweist, die zwischen der Matrix aus Pixeln (108) und den Abschnitten aus optisch transparentem Material (116) angeordnet sind, sowie eine zweite Matrix aus Farbfiltern (204), die die Abschnitte aus optisch transparentem Material (116) bedecken, wobei jedes Filter der ersten Matrix (202) eine der Gruppen von Pixeln (108) bedeckt und jedes Filter der zweiten Matrix (204) einen der Abschnitte aus optisch transparentem Material (116) bedeckt, wobei die Lichtabsorptionsspektren von zwei im Wesentlichen übereinanderliegenden Farbfiltern der ersten (202) und der zweiten Matrix (204) im Wesentlichen ähnlich sind.

10. Abbildungsvorrichtung (200, 300) nach Anspruch 9, wobei die erste (202) und/oder die zweite Matrix (204) der Farbfilter erste (206a), zweite (206b), dritte (206c) und vierte (206d) Farbfilter aufweist, die unterschiedliche Lichtabsorptionsspektren aufweisen.

11. Abbildungsvorrichtung (100 - 300) nach einem der Ansprüche 3 bis 10, wobei zumindest ein Teil der Abschnitte aus optisch transparentem Material (116a, 116b, 116c) eine Eintrittsfläche zum Eintritt der Lichtstrahlen aufweist, die einen hohl ausgeführten Diopter bildet.

12. Abbildungsvorrichtung (400 - 600) nach einem der vorangehenden Ansprüche, wobei jedes der ersten, zweiten und dritten Fokussierungsmittel (404) eine erste (404a), eine zweite (404b) bzw. eine dritte Linse (404c) aufweist, die unterschiedliche Konvergenzen haben.

13. Abbildungsvorrichtung (400) nach Anspruch 12, wobei die vierten Mittel Abschnitte aus lichtundurchlässigem Material (406) aufweisen, die zwischen den Linsen (404) angeordnet sind.

14. Abbildungsvorrichtung (400) nach einem der Ansprüche 12 oder 13, ferner enthaltend zumindest eine Schicht aus optisch transparentem Material (402), die zwischen der Matrix von Pixeln (108) und den Linsen (404) angeordnet ist.

15. Abbildungsvorrichtung (400 - 600) nach einem der Ansprüche 12 bis 14, wobei die ersten oder die zweiten oder die dritten Linsen (404b) Kugelabschnitten entsprechen, deren Mittelpunkte im Wesentlichen den Mittelpunkten der Gruppen von Pixeln (108) entsprechenden, die den Linsen (404b) zugeordnet sind.

16. Abbildungsvorrichtung (500) nach einem der Ansprüche 12 bis 15, wobei die vierten Mittel eine Matrix aus optischen Filtern (502) aufweisen, die zwischen der Matrix von Pixeln (108) und den Linsen (404) angeordnet sind, wobei jedes optische Filter der Matrix (502) eine der Gruppen von Pixeln (108) bedeckt, wobei die Lichtabsorptionsspektren von zwei aneinandergrenzenden optischen Filtern unterschiedlich sind.

17. Abbildungsvorrichtung (600) nach einem der Ansprüche 12 bis 15, wobei die vierten Mittel aufweisen:

    - erste optische Filter (608), deren Lichtabsorptionsspektren die Wellenlängen in dem sichtbaren Bereich unterbrechen und zumindest einen Teil der Wellenlängen des Infrarotbereichs und/oder UV-Bereichs durchlassen, wobei jedes erste optische Filter (608) zwischen einer Linse (404) und der Gruppe von Pixeln (108) angeordnet ist, die der Linse (404) zugeordnet sind,
    - zweite optische Filter (606), deren Lichtabsorptionsspektren einen Teil der Wellenlängen des sichtbaren Bereichs durchlassen und die Wellenlängen des Infrarotbereichs und UV-Bereichs unterbrechen,
wobei die ersten (608) und die zweiten optischen Filter (606) innerhalb einer gleichen Matrix von optischen Filtern abwechselnd angeordnet sind, die zwischen der Matrix von Pixeln (108) und den Linsen (404) angeordnet sind.

18. Abbildungsvorrichtung (400 - 600) nach einem der Ansprüche 12 bis 17, ferner enthaltend ein optisches System (150), das dazu geeignet ist, die von der Szenerie stammenden Lichtstrahlen (154) zur Matrix von Pixeln (108) zu leiten.

19. Abbildungsvorrichtung (400 - 600) nach Anspruch 18, wobei jede Linse (404) gegenüber einer Geraden zentriert ist, die durch den optischen Mittelpunkt des optischen Systems (150) und durch den Mittelpunkt der Gruppe von Pixeln (108) verläuft, die der Linse (404) zugeordnet sind.

20. Abbildungsvorrichtung (100 - 600) nach einem der Ansprüche 7, 8, 18 oder 19, wobei das optische System (150) mit zumindest einem Spiegel (304) gekoppelt ist, der zumindest ein Loch (306) derart aufweist, dass ein erster Teil (312) der Lichtstrahlen zum Abbildungsschaltkreis (101) von Teilen des Spiegels (304) reflektiert wird, die peripher bezüglich des Lochs (306) liegen, und dass ein zweiter Teil (308) der Lichtstrahlen durch das Loch (306) zu einem weiteren Abbildungsschaltkreis (310) geleitet wird.

21. Abbildungsvorrichtung (100 - 600) nach einem der vorangehenden Ansprüche, wobei die Fokussierungsmittel (116, 404) auf Lücke zueinander angeordnet sind.

22. Abbildungsvorrichtung (100 - 600) nach einem der Ansprüche 1 bis 20, wobei die Fokussierungsmittel (116, 404) in Form einer Matrix so angeordnet sind, dass jede Gruppe von fünf fluchtenden Fokussierungsmitteln (116, 404) zumindest jeweils eines aus ersten, zweiten und dritten Fokussierungsmitteln aufweist.

23. Abbildungsvorrichtung (100 - 600) nach einem der vorangehenden Ansprüche, wobei elektrische Verbindungsleitungen (104), die elektrisch mit Fotodetektoren für die Pixel (108) verbunden sind, am Umfang der Gruppen von Pixeln (108) angeordnet sind.

**Claims**

1. An imager device (100-600) including at least:

    - one imager integrated circuit (101) comprising a matrix of pixels (108) for receiving light rays (154) from a scene,

- several first (116a, 404a), second (116b, 404b) and third (116c, 404c) focusing means provided side by side on the matrix of pixels (108), between the matrix of pixels (108) and an inlet face (152) for the light rays (154) in the imager device (100-600), such that each of said focusing means (116, 404) is provided facing a group of at least four said pixels (108) associated with said focusing means (116, 404) and forming a 2x2 matrix, and is capable of focusing part of the light rays to said group of associated pixels, **characterized in that** the focusing performed by the first, second and third focusing means (116, 404) being different from one another and equivalent to an arrangement of group of associated pixels at three distances which are different towards the inlet face (152) for the light rays in the imager device (100-600),

- fourth means (113, 114, 202, 204, 406, 504, 608) capable of passing, with respect to each group of pixels (108), the light rays directed towards said group of pixels (108) and passing through the focusing means (116, 404) associated with said group of pixels (108), and capable of blocking the light rays directed towards said group of pixels (108) and passing through the other focusing means (116, 404).

2. The imager device (100-600) according to claim 1, further including calculating means capable of calculating, from electric signals delivered by the pixels (108), a distance between the imager device (100, 200, 300) and at least one element of the scene.

3. The imager device (100-300) according to one of previous claims, wherein each of the first, second and third focusing means (116) includes a first (116a), a second (116b) and a third (116c) portions respectively of at least one optically transparent material having non-zero thicknesses $e_1$, $e_2$ and $e_3$ and such that $e_1 > e_2 > e_3$, and wherein the refractive index of the optically transparent material is different from the refractive index of a material and/or a gas (118) present between the inlet face (152) for the light rays (154) and the focusing means (116).

4. The imager device (100-300) according to claim 3, wherein, for each of the portions of optically transparent material (116a, 116b, 116c), at least two of the adjacent portions of optically transparent material include thicknesses which are different from that of said portion of optically transparent material.

5. The imager device (100, 300) according to one of claims 3 or 4, wherein the fourth means include at least one opaque layer (113) covering the portions of optically transparent material (116) and through which passes a plurality of apertures (114) each forming, with respect to each of said group of pixels (108), a diaphragm.

6. The imager device (100, 300) according to claim 5, wherein each aperture (114) includes, in a plane parallel to the inlet face (152) for the light rays (154) in the imager device (100, 300), a substantially circular section and/or wherein the centre of each aperture (114) is spaced apart from the centre of a neighbouring aperture (114) by a distance higher than about twice a dimension of a pixel (108) and/or wherein each aperture (114) has dimensions lower than those of one of said group of four pixels (108) and/or wherein each aperture (114) is substantially centred facing a boundary between two adjacent pixels (108).

7. The imager device (100-300) according to one of claims 3 to 6, further including an optical system (150) capable of guiding the light rays (154) from the scene to the matrix of pixels (108).

8. The imager device (100, 300) according to claims 5 and 7, wherein each aperture (114) is centred with respect to a straight line going through the optical centre of the optical system (150) and the centre of the group of pixels (108) the aperture (114) of which forms a diaphragm.

9. The imager device (200, 300) according to one of claims 3 to 8, wherein the fourth means include a first matrix of colour filters (202) provided between the matrix of pixels (108) and the portions of optically transparent material (116), and a second matrix of colour filters (204) covering the portions of optically transparent material (116), each filter of the first matrix (202) covering one of said groups of pixels (108) and each filter of the second matrix (204) covering one said portions of optically transparent material (116), the light absorption spectra of two substantially superimposed colour filters of the first (202) and the second (204) matrix being substantially similar.

10. The imager device (200, 300) according to claim 9, wherein the first (202) and/or the second (204) matrix of colour filters include first (206a), second (206b), third (206c) and fourth (206d) colour filters comprising different light absorption spectra.

11. The imager device (100-300) according to one of claims 3 to 10, wherein at least part of the portions of optically transparent material (116a, 116b, 116c) includes an inlet surface for the light rays forming a concave dioptre.

12. The imager device (400-600) according to one of previous claims, wherein each of the first, second and third focusing means (404) includes a first (404a), second (404b) and third (404c) lenses respectively having different convergences.

13. The imager device (400) according to claim 12, wherein the fourth means include portions of opaque material (406) provided between the lenses (404).

14. The imager device (400) according to one of claims 12 or 13, further including at least one layer of optically transparent material (402) which is provided between the matrix of pixels (108) and the lenses (404).

15. The imager device (400-600) according to one of claims 12 to 14, wherein the first or second or third lenses (404b) correspond to portions of spheres the centres of which substantially correspond to the centres of the group of pixels (108) associated with said lenses (404b).

16. The imager device (500) according to one of claims 12 to 15, wherein the fourth means include a matrix of optical filters (502) provided between the matrix of pixels (108) and the lenses (404), each optical filter of the matrix (502) covering one of said groups of pixels (108), the light absorption spectra of two adjacent optical filters being different.

17. The imager device (600) according to one of claims 12 to 15, wherein the fourth means include:

- first optical filters (608) the light absorption spectra of which cut off the wavelengths in the visible region and pass at least part of the wavelengths of the infrared and/or ultraviolet region, each first optical filter (608) being provided between a lens (404) and the group of pixels (108) associated with said lens (404),
- second optical filters (606) the light absorption spectra of which pass part of the wavelengths of the visible region and cut off the wavelengths of the infrared and ultraviolet region, the first (608) and second (606) optical filters being alternately provided within a same matrix of optical filters which is provided between the matrix of pixels (108) and the lenses (404).

18. The imager device (400-600) according to one of claims 12 to 17, further including an optical system (150) capable of guiding the light rays (154) from the scene to the matrix of pixels (108).

19. The imager device (400-600) according to claim 18, wherein each lens (404) is centred with respect to a straight line going through the optical centre of the optical system (150) and the centre of the group of pixels (108) associated with said lens (404).

20. The imager device (100-600) according to one of claims 7, 8, 18 or 19, wherein the optical system (150) is coupled to at least one mirror (304) comprising at least one hole (306) such that a first part (312) of the light rays are reflected to said imager integrated circuit (101) by the parts of the mirror (304) which are a peripheral to the hole (306) and a second part (308) of the light rays are guided to another imager integrated circuit (310) through the hole (306).

21. The imager device (100-600) according to one of previous claims, wherein the focusing means (116, 404) are arranged in a staggered row with respect to each other.

22. The imager device (100-600) according to one of claims 1 to 20, wherein the focusing means (116, 404) are provided as a matrix such that each group of five aligned focusing means (116, 404) include at least one of each of the first, second and third focusing means.

23. The imager device (100-600) according to one of the preceding claims, wherein electric interconnection lines (104) electrically connected to photodetectors of the pixels (108) are provided at the periphery of said group of pixels (108).

FIG. 1

FIG. 2

FIG. 3

FIG. 4

FIG. 5

## FIG. 6

## FIG. 7

206a   206b   206a   206b
                206c              206d

206d

206c

206a

206b

206c   206d

# FIG. 8

114          113

116

108

101

# FIG. 9

FIG. 10

FIG. 11

FIG. 12

FIG. 13

FIG. 14

**EP 2 518 770 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2299491 A